# EUROPEAN PATENT APPLICATION

(11) **EP 4 648 578 A2**
(43) Date of publication of application: **12.11.2025**
(21) Application number: 25205426.7
(22) Date of filing: 29.09.2025
(51) Int. Cl.: H10F 19/80, H10F 19/90

(54) **PHOTOVOLTAIC MODULE**

(30) Priority: 31.07.2025 CN 202511067530; 31.07.2025 CN 202521618878 U
(71) Applicant: JINKO SOLAR CO., LTD, ShangRao, Jiangxi 334100 (CN); Zhejiang Jinko Solar Co., Ltd., Haining, Zhejiang 314416 (CN)
(72) Inventor: CHEN, Zhendong, Shangrao, Jiangxi, 334100 (CN); TAO, Wusong, Shangrao, Jiangxi, 334100 (CN); LI, Tingting, Shangrao, Jiangxi, 334100 (CN)
(74) Representative: Ipsilon

(57) **Abstract**

A photovoltaic module is provided, including: a laminate (1) comprising a cell layer (13); an insulating member (3) arranged at an edge of the laminate (1) and in contact with the laminate (1) along a peripheral direction of the laminate (1); and a border frame (2), with the edge of the laminate (1) being positioned within the border frame (2) and with the insulating member (3) being positioned between the edge of the laminate (1) and the border frame (2).

## Description

### TECHNICAL FIELD

The present application relates to the technical field of solar cells, and in particular, to a photovoltaic module.

### BACKGROUND

A photovoltaic module includes a cover plate, an encapsulation layer, and a cell layer that are stacked together. The cell layer is configured to convert light energy into electrical energy. The creepage distance of the cell layer needs to meet specified standards to reduce the risks of electric leakage and short-circuiting in the photovoltaic module under environments such as rain, dust, and salt mist.

Therefore, how to increase the creepage distance of the cell layer is a crucial problem that needs to be solved in the art.

### SUMMARY

The present application provides a photovoltaic module, a cell layer of which has increased creepage distance.

The present application provides a photovoltaic module, including a laminate, an insulating member, and a border frame. The laminate includes a cell layer. The insulating member is arranged at an edge of the laminate and in contact with the laminate along a peripheral direction of the laminate. The edge of the laminate is positioned within the border frame. The insulating member is positioned between the edge of the laminate and the border frame.

In the present application, be providing the insulating member between the edge of the laminate and the border frame, the creepage distance of the solar cell is increased. In some embodiments, a projection of the cell layer is located within a projected outline of the insulating member in a direction perpendicular to a third direction, and the third direction is a thickness direction of the photovoltaic module.

In some embodiments, a distance between the cell layer and the edge of the laminate in a direction perpendicular to a third direction is greater than or equal to 2.8 mm and less than or equal to 20 mm, and the third direction is a thickness direction of the photovoltaic module

In some embodiments, in a plane perpendicular to the third direction, the laminate includes at least a first sidewall, a second sidewall, a third sidewall, and a fourth sidewall, all of which are arranged in a circumferential direction. The insulating member includes at least a first side portion, a second side portion, a third side portion, and a fourth side portion. The first side portion is in contact with the first sidewall, the second side portion is in contact with the second sidewall, the third side portion is in contact with the third sidewall, and the fourth side portion is in contact with the fourth sidewall. The first side portion, the second side portion, the third side portion, and the fourth side portion are constructed as an integrated structure.

In some embodiments, in a plane perpendicular to the third direction, the laminate includes at least a first sidewall, a second sidewall, a third sidewall, and a fourth sidewall, all of which are arranged in a circumferential direction. The insulating member includes at least a first side portion, a second side portion, a third side portion, and a fourth side portion. The first side portion is in contact with the first sidewall, the second side portion is in contact with the second sidewall, the third side portion is in contact with the third sidewall, and the fourth side portion is in contact with the fourth sidewall. The first side portion, the second side portion, the third side portion, and the fourth side portion are constructed as separated structures, with a joint gap formed between adjacent two of the first side portion, the second side portion, the third side portion, and the fourth side portion.

In some embodiments, in a plane perpendicular to the third direction, the joint gap is not parallel to a first direction that is a length direction of the photovoltaic module and is not parallel to a second direction either that is a width direction of the photovoltaic module.

In some embodiments, a minimum distance between the cell layer and the edge of the laminate at the joint gap is denoted as *A21,* and 2.8 mm ≤ *A21* ≤ 11.3 mm. At the joint gap, a distance between the edge of the laminate and an outer edge of the insulating member along the joint gap is denoted as *A22,* and 0.1 mm ≤ *A22* ≤ 8.6 mm.

In some embodiments, in a plane perpendicular to the third direction, the joint gap is parallel to the first direction or the second direction.

In some embodiments, a minimum distance between the cell layer and the edge of the laminate at the joint gap is denoted as *A31,* and 10.5 mm ≤ *A31* ≤ 20 mm. At the joint gap, a distance between the edge of the laminate and an outer edge of the insulating member along the joint gap is denoted as *A32,* and 0.3 mm ≤ *A32* ≤ 0.5 mm.

In some embodiments, the cell layer includes a plurality of cell strings and at least one busbar. The plurality of cell strings are arranged in the first direction, and the busbar extends in the first direction. In the second direction, at least part of the busbar is located between the plurality of cell strings and the edge of the laminate. The busbar is configured for electrically connecting the cell strings. In the first direction, a distance between the busbar and the edge of the laminate is less than a distance between the plurality of cell strings and the edge of the laminate. A distance between the busbar and the edge of the laminate at the joint gap is the *A31*, with 10.5 mm ≤ *A31* ≤15 mm.

In some embodiments, in the first direction, the distance between the cell layer and the edge of the laminate ranges from 6 mm to 10 mm. In the second direction, the distance between the cell layer and the edge of the laminate ranges from 8 mm to 10 mm. The first direction, the second direction, and the third direction are perpendicular to each other.

In some embodiments, the cell layer includes a plurality of cell strings and at least one busbar. The plurality of cell strings are arranged in the first direction, and the busbar extends in the first direction. In the second direction, at least part of the busbar is located between the plurality of cell strings and the edge of the laminate. The busbar is configured for electrically connecting the cell strings. In the first direction, a distance between the plurality of cell strings and the edge of the laminate is denoted as *a1,* and 8 mm ≤ *a1* ≤ 10 mm.

In some embodiments, in the first direction, a distance between the busbar and the edge of the laminate is denoted as *a2. a2 < a1* and 0.5 mm ≤ *a1-a2* ≤ 2 mm. Alternatively, *a2 > a1* and 1mm ≤ *a2-a1* ≤ 8mm.

In some embodiments, the laminate further includes an encapsulation layer. At least a part of the encapsulation layer is located on a light-facing side of the cell layer, and/or at least another part of the encapsulation layer is located on a backlight-facing side of the cell layer. The encapsulation layer at least includes a first adhesive film. In the third direction, a projection of the joint gap is within a projection region of the first adhesive film. The first adhesive film is a waterproof adhesive film.

In some embodiments, a size of the first adhesive film (123) in the first direction (X) is denoted as *H1,* and 10 mm ≤ *H1* ≤ 100 mm. A size of the first adhesive film (123) in the second direction (Y) is denoted as *H2,* and 10 mm ≤ *H2* ≤ 100 mm.

In some embodiments, a projection of the first adhesive film in the third direction is fan-shaped, triangular, rectangular, L-shaped, or concentric-square-shaped.

In some embodiments, the cell layer includes a plurality of cell strings arranged in the first direction. A number of the cell strings in the first direction is greater than or equal to 2. A distance between adjacent two of the plurality of cell strings in the first direction is denoted as *L1,* and 9 mm ≤ *L1* ≤ 11 mm.

In some embodiments, the cell layer includes a plurality of cell strings arranged in the second direction. A number of the cell strings in the second direction (Y) is greater than or equal to 4. A distance between adjacent two of the plurality of cell strings in the second direction (Y) is denoted as *L2,* and 0.5 mm ≤ *L2* ≤ 1.6 mm.

In some embodiments, the cell layer includes at least one cell string. The cell string includes a plurality of cell pieces. A number of the cell pieces included in a single cell string is denoted as *N,* and 8 ≤ *N* ≤ 24. A distance between the adjacent cell pieces is denoted as *L3,* and -0.6 mm ≤ *L3* ≤ 0.8 mm.

In some embodiments, a size of the photovoltaic module in the first direction is denoted as *S1,* and 1700 mm ≤ *S1* ≤ 2400 mm. A size of the photovoltaic module in the second direction is denoted as *S2,* and 1100 mm ≤ *S*2 ≤ 1350 mm.

It should be understood that the above general description and the following detail description are only exemplary and cannot be constructed as limiting the present application.

### BRIEF DESCRIPTION OF THE DRAWINGS

FIG. 1 is a schematic structural view of a light-facing surface of a photovoltaic module provided in some embodiments of the present application;
FIG. 2 is a partial sectional structural view of a photovoltaic module provided in a first embodiment of the present application;
FIG. 3 is a sectional structural view of a laminate provided in some embodiments of the present application;
FIG. 4 is a schematic view of a connection structure of a cell layer provided in some embodiments of the present application;
FIG. 5 is a partial sectional structural view of a photovoltaic module provided in a second embodiment of the present application;
FIG. 6 is a partial sectional structural view of a photovoltaic module provided in a third embodiment of the present application;
FIG. 7 is a schematic view of a connection structure between a laminate and an insulating member in FIG. 6 in some embodiments;
FIG. 8 is a schematic view illustrating a position of a cell layer of the laminate in FIG. 7;
FIG. 9 is a schematic structural view of the cell layer in FIG. 8 in some embodiments;
FIG. 10 is a schematic structural view of the cell layer in FIG. 8 in some other embodiments;
FIG. 11 is a schematic view of a connection structure between the laminate and the insulating member in FIG. 6 in some other embodiments;
FIG. 12 is a schematic view of an arrangement position of a cell layer at a joint gap in FIG. 11;
FIG. 13 is a schematic structural view of the cell layer in FIG. 12 in some embodiments;
FIG. 14 is a schematic structural view of the cell layer in FIG. 12 in some other embodiments;
FIG. 15 is a schematic view of a connection structure between the laminate and the insulating member in FIG. 6 in yet other embodiments;
FIG. 16 is a schematic view of an arrangement position of a cell layer at a joint gap in FIG. 15;
FIG. 17 is a schematic structural view of the cell layer in FIG. 16 in some embodiments;
FIG. 18 is a schematic structural view of the cell layer in FIG. 16 in some other embodiments;
FIG. 19 is a schematic structural view of a laminate in some embodiments;
FIG. 20 is a schematic structural view of a laminate in some other embodiments; and
FIG. 21 is a schematic structural view of a laminate in yet other embodiments.

### Reference numerals:

1-laminate; 11-cover plate; 111-first cover plate; 112-second cover plate; 12-encapsulation layer; 121-first encapsulation layer; 122-second encapsulation layer; 123-first adhesive film; 124-second adhesive film; 13-cell layer; 131-cell piece; 132-solder ribbon; 133-busbar; 14-first sidewall; 15-second sidewall; 16-third sidewall; 17-fourth sidewall;

### 2-border frame; 21-border frame body; 22-adhesive layer;

3-insulating member; 31-first side portion; 32-second side portion; 33-third side portion; 34-fourth side portion; and 35-joint gap.

### DETAILED DESCRIPTION

To make the technical solutions of the present application more understandable, detailed descriptions of specific embodiments of the present application are provided below in conjunction with accompanying drawings.

The terms used in the embodiments of the present application are merely used for the purpose of describing specific embodiments and are not intended to limit the present application. Singular forms including "a", "an", and "the" used in the embodiments and claims of the present application are intended to include a plural form, except that the context clearly expresses other meanings.

It should be understood that the term "and/or" used herein is merely a description of an association relationship between associated objects, indicating that there may be three relationships. For example, A and/or B may represent: A exists alone, A and B exist together, or B exists alone. In addition, the character "/" herein generally means that the associated objects before and after it are in an "or" relationship.

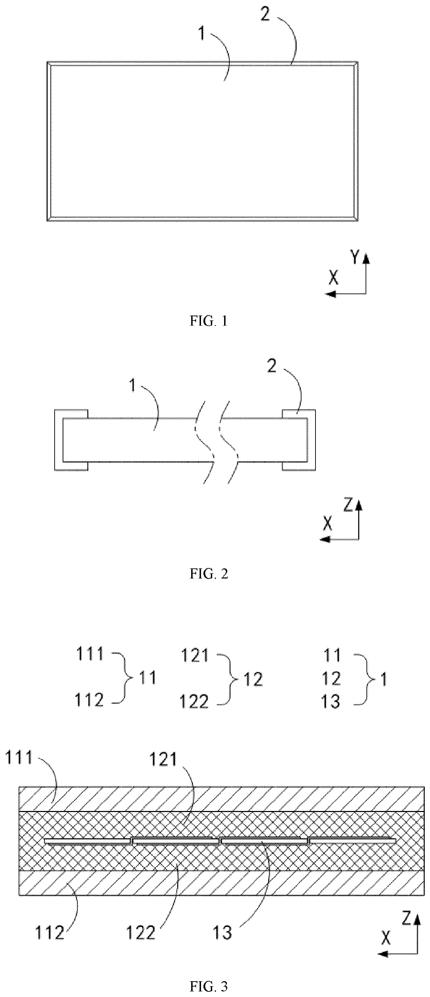

Embodiments of the present application provide a photovoltaic module. FIG. 1 is a schematic structural view of a light-facing surface of the photovoltaic module in some embodiments. As shown in FIG. 1, the photovoltaic module includes a first direction X and a second direction Y. Both the first direction X and the second direction Y are perpendicular to a thickness direction of the photovoltaic module. Exemplarily, the first direction X is a length direction of the photovoltaic module, and the second direction Y is a width direction of the photovoltaic module.

A size of the photovoltaic module in the first direction X is denoted as *S1,* and 1700 mm ≤ *S1* ≤ 2400 mm. Exemplarily, the size of the photovoltaic module in the first direction X may be 1700 mm, 1800 mm, 1900 mm, 2000 mm, 2100 mm, 2200 mm, 2300 mm, 2400 mm, etc.

If the size of the photovoltaic module in the first direction X is relatively large, then the cost and weight of the photovoltaic module would be relatively high.

If the size of the photovoltaic module in the first direction X is relatively small, then fewer cell pieces could be provided inside the photovoltaic module, affecting the output power of the photovoltaic module.

Therefore, with 1700 mm ≤ *S1* ≤ 2400 mm, not only the size of the photovoltaic module in the first direction X can be decreased to reduce the cost and weight of the photovoltaic module, but also more cell pieces can be provided inside the photovoltaic module to improve the output power of the photovoltaic module.

Exemplarily, 1700 mm ≤ *S1* ≤ 2000 mm. The size of the photovoltaic module in the first direction X may be 1700 mm, 1710 mm, 1720 mm, 1730 mm, 1740 mm, 1750 mm, 1760 mm, 1770 mm, 1780 mm, 1790 mm, 1800 mm, 1810 mm, 1820 mm, 1830 mm, 1840 mm, 1850 mm, 1860 mm, 1870 mm, 1880 mm, 1890 mm, 1900 mm, 1910 mm, 1920 mm, 1930 mm, 1940 mm, 1950 mm, 1960 mm, 1970 mm, 1980 mm, 1990 mm, 2000 mm, etc.

Exemplarily, 2000 mm ≤ *S1* ≤ 2200 mm. The size of the photovoltaic module in the first direction X may be 2000 mm, 2010 mm, 2020 mm, 2030 mm, 2040 mm, 2050 mm, 2060 mm, 2070 mm, 2080 mm, 2090 mm, 2100 mm, 2110 mm, 2120 mm, 2130 mm, 2140 mm, 2150 mm, 2160 mm, 2170 mm, 2180 mm, 2190 mm, 2200 mm, etc.

Exemplarily, 2200 mm ≤ *S1* ≤ 2400 mm. The size of the photovoltaic module in the first direction X may be 2200 mm, 2210 mm, 2220 mm, 2230 mm, 2240 mm, 2250 mm, 2260 mm, 2270 mm, 2280 mm, 2290 mm, 2300 mm, 2310 mm, 2320 mm, 2330 mm, 2340 mm, 2350 mm, 2360 mm, 2370 mm, 2380 mm, 2390 mm, 2400 mm, etc.

A size of the photovoltaic module in the second direction Y is denoted as *S2,* and 1100 mm ≤ *S2* ≤ 1350 mm. Exemplarily, the size of the photovoltaic module in the second direction Y may be 1100 mm, 1150 mm, 1200 mm, 1250 mm, 1300 mm, 1350 mm, etc.

If the size of the photovoltaic module in the second direction Y is relatively large, then the cost and weight of the photovoltaic module would be relatively high.

If the size of the photovoltaic module in the second direction Y is relatively small, then fewer cell pieces could be provided inside the photovoltaic module, affecting the output power of the photovoltaic module.

Therefore, with 1100mm ≤ *S*2 ≤ 1350mm, not only the size of the photovoltaic module in the second direction Y can be decreased to reduce the cost and weight of the photovoltaic module, but also more cell pieces can be provided inside the photovoltaic module to improve the output power of the photovoltaic module.

Exemplarily, 1100 mm≤*S2*≤1150 mm. The size of the photovoltaic module in the second direction Y may be 1100 mm, 1110 mm, 1120 mm, 1130 mm, 1140 mm, 1150 mm, etc.

Exemplarily, 1150 mm≤*S2*≤1250 mm. The size of the photovoltaic module in the second direction Y may be 1150 mm, 1160 mm, 1170 mm, 1180 mm, 1190 mm, 1200 mm, 1210 mm, 1220 mm, 1230 mm, 1240 mm, 1250 mm, etc.

Exemplarily, 1250 mm ≤ *S*2 ≤ 1350 mm. The size of the photovoltaic module in the second direction Y may be 1250 mm, 1260 mm, 1270 mm, 1280 mm, 1290 mm, 1300 mm, 1310 mm, 1320 mm, 1330 mm, 1340 mm, 1350 mm, etc.

FIG. 2 is a partial sectional structural view of the photovoltaic module according to some embodiments. Referring to FIG. 1 and FIG. 2, the photovoltaic module includes a laminate 1 and a border frame 2. The border frame 2 is clamped and fixed onto an edge of the laminate 1, such that the edge of the laminate 1 is positioned within the border frame 2. The border frame 2 is used to facilitate the installation of the laminate on an object such as a floor, a building, and a bracket. Moreover, the border frame 2 can protect the edge of the laminate 1, thereby reducing the risk of damage to the edge of the laminate 1 due to stress, and thus prolonging the service life of the photovoltaic module.

As shown in FIG. 2, the photovoltaic module further includes a third direction Z. The third direction Z is parallel to the thickness direction of the photovoltaic module. That is, the first direction X, the second direction Y, and the third direction Z are perpendicular to each other.

A sectional shape of the border frame 2 in a plane defined by the first direction X and the third direction Z may be C-shaped or adopt other common border frame shapes. That is, the structure of the border frame is not specifically limited in the embodiments of the present application.

FIG. 3 is a sectional structural view of the laminate according to some embodiments. As shown in FIG. 3, the laminate 1 includes a cover plate 11, an encapsulation layer 12, and a cell layer 13. The encapsulation layer 12 is located between the cover plate 11 and the cell layer 13 in the third direction Z. The encapsulation layer 12 is configured to encapsulate and fix the cover plate 11 and the cell layer 13.

The cover plate 11 includes a first cover plate 111 and a second cover plate 112 stacked in the third direction Z. The encapsulation layer 12 and the cell layer 13 are located between the first cover plate 111 and the second cover plate 112. Part of the encapsulation layer 12 is located between the cell layer 13 and the first cover plate 111, and another part of the encapsulation layer 12 is located between the cell layer 13 and the second cover plate 112 to achieve the encapsulation and fixation of the cover plate 11 and the cell layer 13.

At least one of the first cover plate 111 or the second cover plate 112 is made of a light-transmissible material, which is conducive to improving the photoelectric conversion efficiency of the photovoltaic module.

A material of the first cover plate 111 may be one or more of rigid materials such as tempered glass, polyethylene terephthalate (PET), and polycarbonate (PC). Alternatively, the material of the first cover plate 111 may be one or more of flexible materials such as polyvinyl fluoride (PVF), ethylene-tetra-fluoro-ethylene (ETFE), and polyvinylidene fluoride (PVDF). All the above materials exhibit high light transmittance, which ensures that more light can be transmitted to the cell layer, thereby increasing the light absorption by the photovoltaic module and improving the photoelectric conversion efficiency of the photovoltaic module.

A material of the second cover plate 112 may be one or more of rigid materials such as tempered glass, polyethylene terephthalate (PET), and polycarbonate (PC). Alternatively, the material of the second cover plate 112 may be one or more of flexible materials such as polyvinyl fluoride (PVF), ethylene-tetra-fluoro-ethylene (ETFE), and polyvinylidene fluoride (PVDF).

The materials of the first cover plate 111 and the second cover plate 112 may be the same or different.

Continuing to refer to FIG. 3, the encapsulation layer 12 includes a first encapsulation layer 121 and a second encapsulation layer 122. In the third direction Z, a part of the first encapsulation layer 121 is located between the cell layer 13 and the first cover plate 111, and another part of the second encapsulation layer 122 is located between the cell layer 13 and the second cover plate 112.

A material of the first encapsulation layer 121 is one or more of polyolefins such as ethylene-vinyl acetate copolymer (EVA), polyolefin elastomer (POE), and polyvinyl butyral (PVB). The above materials have relatively high light transmittance, which is conducive to improving the photoelectric conversion efficiency of the photovoltaic module. The first encapsulation layer 121 may be an EPE adhesive film (EVA-POE-EVA co-extruded structure) or an EP adhesive film (EVA-POE co-extruded structure).

A material of the second encapsulation layer 122 is one or more of polyolefins such as ethylene-vinyl acetate copolymer (EVA), polyolefin elastomer (POE), and polyvinyl butyral (PVB). The second encapsulation layer 122 may be an EPE adhesive film (EVA-POE-EVA co-extruded structure) or an EP adhesive film (EVA-POE co-extruded structure).

The materials of the first encapsulation layer 121 and the second encapsulation layer 122 may be the same or different.

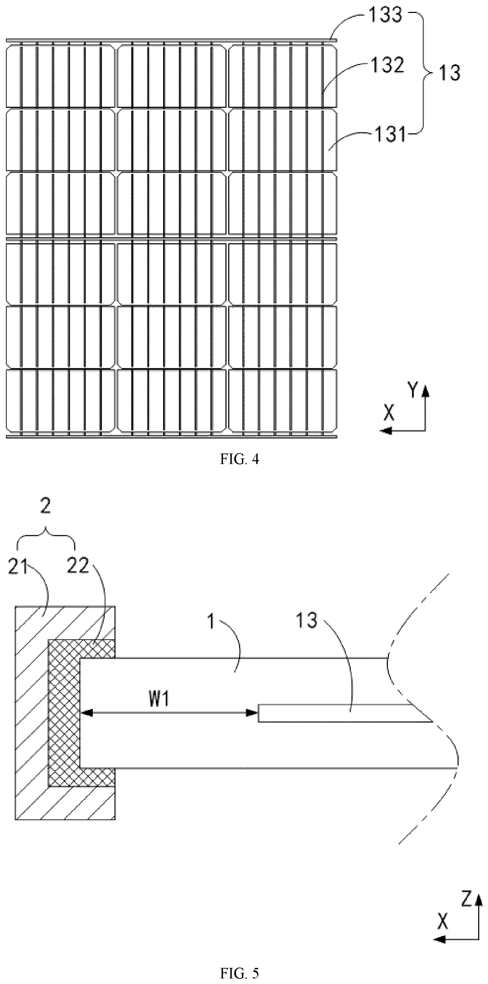

FIG. 4 is a schematic view of a connection structure for the cell layer according to some embodiments. As shown in FIG. 4, the cell layer 13 includes a plurality of cell pieces 131, every two adjacent cell pieces 131 are connected through a solder ribbon 132, the solder ribbons 132 connect the plurality of cell pieces 131 in series to form a cell string, and adjacent cell strings are electrically connected through a busbar 133, thereby achieving series or parallel connections among the plurality of cell strings to enhance the performance of the photovoltaic module.

The types of the cell pieces 131 include, but are not limited to, a passivated emitter rear cell (PERC), a tunnel oxide passivated contact (TOPCon) cell, a heterojunction with intrinsic thin-film (HJT) cell, an interdigitated back contact (IBC) cell, a perovskite cell, etc.

For the PERC cell, in a thickness direction thereof, the PERC cell sequentially includes a front-surface metallic silver electrode, a front-surface silicon nitride passivation layer, a phosphorus-doped emitter, a P-type silicon substrate layer, a local aluminum back surface field, a metallic aluminum back electrode, and a back passivation layer (Al₂O₃/SiNₓ). The PERC cell employs a passivation film to passivate a back surface, replacing a full aluminum back surface field, enhancing internal back reflection of light within the silicon substrate, reducing a recombination rate at the back surface, and improving the cell efficiency by 0.5% to 1%.

For the TOPCon cell, in a thickness direction thereof, the TOPCon cell sequentially includes a metallic silver electrode, a front-surface silicon nitride passivation layer, a boron-doped emitter, an N-type silicon substrate layer, a diffusion-doped layer, an ultra-thin silicon oxide layer, a doped polycrystalline silicon layer, a silicon nitride layer, and a metallic silver electrode. A back surface of the cell is composed of an ultra-thin silicon oxide layer (1 nm to 2 nm) and a phosphorus-doped microcrystalline-amorphous mixed Si thin film, which together form a passivated contact structure. The structure may block recombination of minority carrier holes, and enhance the cell open-circuit voltage and short-circuit current. The ultra-thin oxide layer may allow majority carrier electrons to tunnel into the polycrystalline silicon layer while blocking the recombination of minority carrier holes. An excellent passivation effect of the ultra-thin silicon oxide and the heavily doped silicon thin film causes band bending at a surface of the silicon wafer, resulting in a field passivation effect. This significantly increases the probability of electron tunneling, reduces contact resistance, and improves the cell open-circuit voltage and short-circuit current, thereby improving the cell conversion efficiency.

For the HJT cell, in a thickness direction thereof, the HJT cell sequentially includes a front-surface low-temperature silver electrode, a front-surface conductive thin film, an N-type amorphous silicon thin film, an intrinsic amorphous silicon thin film, an N-type silicon substrate layer, an intrinsic amorphous silicon thin film, a P-type amorphous silicon thin film, a back-surface conductive thin film, and a back-surface low-temperature silver electrode.

For the IBC cell, in a thickness direction thereof, the IBC cell sequentially includes a silicon nitride anti-reflection layer, an N+ front surface field, an N-type silicon substate layer, a P+ emitter, an N+ back surface field, an aluminum oxide passivation layer, a silicon nitride anti-reflection layer, and a metallic silver electrode. The IBC cell employs an ion implantation technology to achieve a P-type region and an N-type region with excellent uniformity and precisely controllable junction depths. With no grid lines obstructing a front surface of the cell, shading current losses caused by metal electrodes can be eliminated, thereby achieving maximum utilization of incident photons and increasing a short-circuit current by approximately 7% compared to conventional solar cells. Due to the back contact structure, there is no need to consider the issue of grid line shading, allowing for an appropriate increase in a grid line width ratio, thereby reducing series resistance and resulting in a high fill factor. Additionally, optimized designs for surface passivation and surface light-trapping structures can be implemented, leading to a low front-surface recombination rate and reduced surface reflection.

For the perovskite cell, in a thickness direction thereof, the perovskite cell sequentially includes a substrate material, a conductive thin film, an electron transport layer (titanium dioxide), a perovskite absorption layer (hole transport layer), and a metallic cathode. The perovskite material has a high light absorption coefficient and a long carrier diffusion distance. After photons absorbed by the perovskite material are converted into electrons, these electrons are easily collected by electrodes with minimal losses, which results in the generation of a high photogenerated voltage and current, thereby allowing the perovskite cell to demonstrate high photoelectric conversion efficiency.

The specific type of the cell piece 131 is not particularly limited in this embodiment of the present application.

The cell layer includes the plurality of cell strings arranged in the first direction X. The number of the cell strings in the first direction X is greater than or equal to 2. Exemplarily, the number of the cell strings in the first direction X may be 2, 3, 4, 5, 6, 7, 8, 9, 10, or even more.

A distance between the adjacent cell strings in the first direction X is denoted as *L1,* and 9 mm ≤ *L1* ≤ 11 mm. Exemplarily, the distance between the adjacent cell strings in the first direction X may be 9 mm, 10 mm, 11 mm, etc.

If the distance between the adjacent cell strings is relatively small, then the difficulty of arranging the cell strings in the manufacturing process of the photovoltaic module would be increased, posing risks such as contact, misalignment, and overlap between the cell strings, thereby increasing the risk of hidden cracks in the cell pieces during the lamination process.

If the distance between the adjacent cell strings is relatively large, the number of the cell strings arranged in the first direction X is reduced, thereby decreasing the output power and photoelectric conversion efficiency of the photovoltaic module.

Therefore, with 9 mm ≤ *L1* ≤ 11 mm, not only the difficulty of arranging the cell strings, as well as the risks of contact, misalignment, and overlap between the cell strings are reduced, thereby decreasing the risk of hidden cracks in the manufacturing process of the photovoltaic module and facilitating an improvement in a processing yield of the photovoltaic module, but also the number of the cell strings arranged in the first direction X can also be increased, thereby enhancing the output power and photoelectric conversion efficiency of the photovoltaic module.

Exemplarily, 9 mm ≤ *L1* ≤ 10 mm. The distance between the adjacent cell strings in the first direction X may be 9 mm, 9.1 mm, 9.2 mm, 9.3 mm, 9.4 mm, 9.5 mm, 9.6 mm, 9.7 mm, 9.8 mm, 9.9 mm, 10 mm, etc.

Exemplarily, 10 mm ≤ *L1* ≤ 11 mm, the distance between the adjacent cell strings in the first direction X may be 10 mm, 10.1 mm, 10.2 mm, 10.3 mm, 10.4 mm, 10.5 mm, 10.6 mm, 10.7 mm, 10.8 mm, 10.9 mm, 11 mm, etc.

The cell layer includes a plurality of cell strings arranged in the second direction Y. The number of the cell strings in the second direction Y is greater than or equal to 4. Exemplarily, the number of the cell strings in the second direction Y may be 4, 5, 6, 7, 8, 9, 10, or even more.

A distance between the adjacent cell strings in the second direction Y is denoted as *L2,* and 0.5 mm ≤ *L2* ≤ 1.6 mm. Exemplarily, the distance between the adjacent cell strings in the second direction Y may be 0.5 mm, 0.6 mm, 0.7 mm, 0.8 mm, 0.9 mm, 1 mm, 1.1 mm, 1.2 mm, 1.3 mm, 1.4 mm, 1.5 mm, 1.6 mm, etc.

If the distance between the adjacent cell strings is relatively small, then the difficulty of arranging the cell strings in the manufacturing process of the photovoltaic module would be increased, posing risks such as contact, misalignment, and overlap between the cell strings, thereby increasing the risk of hidden cracks in the cell pieces during the lamination process.

If the distance between the adjacent cell strings is relatively large, then the number of the cell strings arranged in the second direction Y would be reduced, thereby decreasing the output power and photoelectric conversion efficiency of the photovoltaic module.

Therefore, with 0.5 mm ≤ *L2* ≤ 1.6 mm, not only the difficulty of arranging the cell strings, as well as the risks of contact, misalignment, and overlap between cell strings are reduced, thereby decreasing the risk of hidden cracks in the manufacturing process of the photovoltaic module and facilitating an improvement in a processing yield of the photovoltaic module, but also the number of the cell strings arranged in the second direction Y can be increased, thereby enhancing the output power and photoelectric conversion efficiency of the photovoltaic module.

Exemplarily, 0.5 mm ≤ *L2* ≤ 1 mm. The distance between the adjacent cell strings in the second direction Y may be 0.5 mm, 0.52 mm, 0.54 mm, 0.56 mm, 0.58 mm, 0.6 mm, 0.62 mm, 0.64 mm, 0.66 mm, 0.68 mm, 0.7 mm, 0.72 mm, 0.74 mm, 0.76 mm, 0.78 mm, 0.8 mm, 0.82 mm, 0.84 mm, 0.86 mm, 0.88 mm, 0.9 mm, 0.92 mm, 0.94 mm, 0.96 mm, 0.98 mm, 1 mm, etc.

Exemplarily, 1 mm ≤ *L2* ≤ 1.6 mm. The distance between the adjacent cell strings in the second direction Y may be 1 mm, 1.02 mm, 1.04 mm, 1.06 mm, 1.08 mm, 1.1 mm, 1.12 mm, 1.14 mm, 1.16 mm, 1.18 mm, 1.2 mm, 1.22 mm, 1.24 mm, 1.26 mm, 1.28 mm, 1.3 mm, 1.32 mm, 1.34 mm, 1.36 mm, 1.38 mm, 1.4 mm, 1.42 mm, 1.44 mm, 1.46 mm, 1.48 mm, 1.5 mm, 1.52 mm, 1.54 mm, 1.56 mm, 1.58 mm, 1.6 mm, etc.

The cell layer includes at least one cell string. A single cell string includes a plurality of cell pieces. The number of the cell pieces in a single cell string is denoted as *N*, and 8 ≤ *N* ≤ 24. Exemplarily, the number of the cell pieces in a single cell string may be 8, 9, 10, 11, 12, 13, 14, 15, 16, 17, 18, 19, 20, 21, 22, 23, or 24.

If a single cell string includes a relatively small number of cell pieces, then more cell strings would be required to achieve the desired power output, which increases the cost of the photovoltaic module.

If a single cell string includes a relatively large number of cell pieces, then the voltage and temperature of the cell string would be higher, making heat dissipation difficult.

Therefore, with 8 ≤ *N* ≤ 24, not only the number of cell strings can be reduced to lower the cost of the photovoltaic module, but also the voltage and temperature of the cell strings can be reduced to reduce the difficulty of heat dissipation in the photovoltaic module.

Within a single cell string, a distance between adjacent cell pieces is denoted as *L3,* and -0.6 mm ≤ *L3* ≤ 0.8 mm. Exemplarily, the distance between the adjacent cell pieces may be -0.6 mm, -0.5 mm, -0.4 mm, -0.3 mm, -0.2 mm, -0.1 mm, 0 mm, 0.1 mm, 0.2 mm, 0.3 mm, 0.4 mm, 0.5 mm, 0.6 mm, 0.7 mm, 0.8 mm, etc.

If the distance between the adjacent cell pieces is relatively small, there would be risks such as reduced output power and increased local temperature due to cell piece shading.

If the distance between the adjacent cell pieces is relatively large, the number of cell pieces that can be arranged would need to be reduced, which also affects the output power of the photovoltaic module.

Therefore, with -0.6 mm ≤ *L3* ≤ 0.8 mm, not only the risks of reduced output power and increased local temperature due to cell piece shading can be reduced, but also the number of cell pieces that can be arranged can be increased to increase the output power of the photovoltaic module.

Exemplarily, -0.6 mm ≤ *L3* ≤ 0 mm. The distance between the adjacent cell pieces may be -0.6 mm, -0.55 mm, -0.5 mm, -0.45 mm, -0.4 mm, -0.35 mm, -0.3 mm, -0.25 mm, -0.2 mm, -0.15 mm, -0.1 mm, -0.05 mm, 0 mm, etc.

Exemplarily, 0 mm ≤ *L3* ≤ 0.8 mm. The distance between the adjacent cell pieces may be 0 mm, 0.1 mm, 0.15 mm, 0.2 mm, 0.25 mm, 0.3 mm, 0.35 mm, 0.4 mm, 0.45 mm, 0.5 mm, 0.55 mm, 0.6 mm, 0.65 mm, 0.7 mm, 0.75 mm, 0.8 mm, etc.

FIG. 5 is a partial sectional structural view of the photovoltaic module provided in some embodiments of the present application. As shown in FIG. 5, the border frame 2 includes a border frame body 21 and an adhesive layer 22. The adhesive layer 22 is located between the border frame body 21 and the laminate 1, and is configured to bond and fix the border frame body 21 to the laminate 1.

A creepage distance of the photovoltaic module refers to a shortest path measured along an insulating surface between two conductive components or between a conductive component and a device protective interface. As a critical factor in evaluating the performance of the photovoltaic module, an insufficient creepage distance tends to cause electrical tracking or arc discharge, adversely affecting the cell performance and safety performance of the photovoltaic module.

According to an international electrotechnical commission (IEC) standard, the system voltage and minimum creepage distance of the photovoltaic module must satisfy a specific correspondence. Exemplarily, when the system voltage of the photovoltaic module is 1500 V and a pollution level of the photovoltaic module is 1, the minimum creepage distance of the photovoltaic module is 10.4 mm, indicating that the creepage distance should be greater than 10.4 mm.

In the photovoltaic module shown in FIG. 5, the creepage distance *W1* of the photovoltaic module refers to a shortest straight-line distance between the cell layer 13 and the border frame 2 in a plane perpendicular to the third direction Z. Exemplarily, as shown in FIG. 5, the creepage distance *W1* may be understood as a shortest straight-line distance between the cell layer 13 and an outer edge of the laminate 1 in the first direction X. As such, *W1* should be equal to or greater than 10.4 mm.

Based on the structure shown in FIG. 5, to further increase the creepage distance *W1,* it is necessary to increase the distance between the cell layer 13 and the border frame 2 in the first direction X, i.e., to increase the distance between the cell layer 13 and the outer edge of the laminate 1.

When the overall size of the photovoltaic module is fixed at a predetermined value, increasing the distance between the cell layer 13 and the border frame 2 in the first direction X may cause reduced number of the cell pieces included in the cell layer 13, thereby decreasing the output power of the photovoltaic module.

When the output power of the photovoltaic module and the number of the cell pieces included in the cell layer 13 are fixed at predetermined values, increasing the distance between the cell layer 13 and the border frame 2 in the first direction X may cause increased overall size of the photovoltaic module.

Therefore, the structure of the photovoltaic module needs to be adjusted to balance the relationship among the creepage distance, the number of the cell pieces, and the overall size of the photovoltaic module.

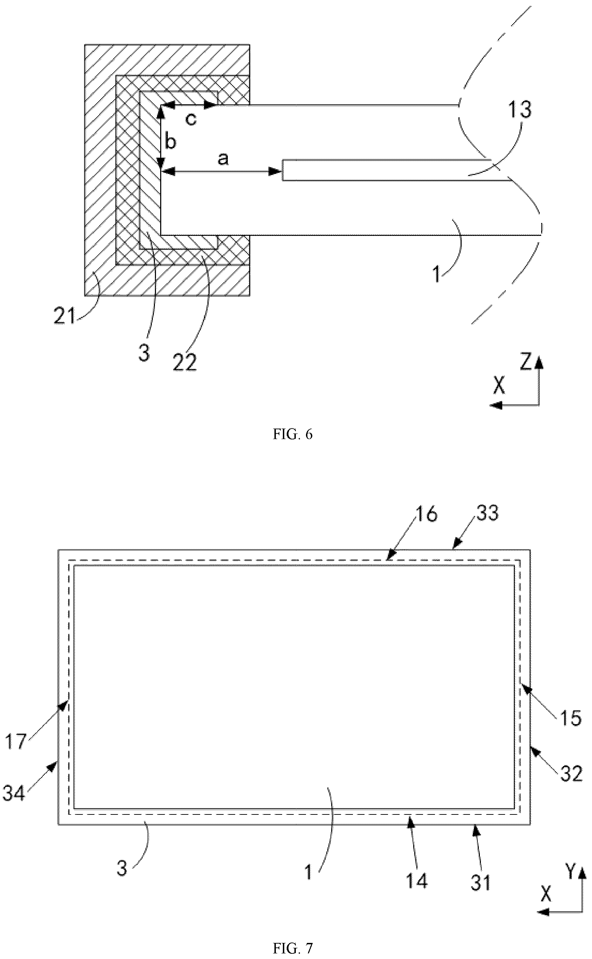

FIG. 6 is a partial sectional structural view of the photovoltaic module provided in some embodiments of the present application. As shown in FIG. 6, the photovoltaic module further includes an insulating member 3. The insulating member 3 is located between the border frame 2 and the laminate 1. That is, the insulating member 3 is disposed at an edge of the laminate 1 and in contact with the laminate 1. Furthermore, a projection of the cell layer 13 is located within a projected outline of the insulating member 3 in a direction perpendicular to the third direction Z.

In this case, an assembling process of the photovoltaic module is as follows:
S1: attach the insulating member 3 to the edge of the laminate 1;
S2: filling a bonding adhesive into the border frame body 21 to form the adhesive layer 22;
S3: positioning the edge of the laminate 1 into the border frame body 21, such that at least part of the insulating member 3 is located inside the border frame body 21, thereby clamping and fixing the border frame body 21 onto the edge of the insulating member 3.

In the embodiments of the present application, the sequence of the step S1 and the step S2 is not specifically limited. The step S1 may be performed before the step S2, or the step S2 may be performed before the step S1, or the step S1 and the step S2 may be performed simultaneously.

As shown in FIG. 6, a straight-line distance between the cell layer 13 and the insulating member 3 in the first direction X is denoted as *a.* A straight-line distance between a center line of the cell layer 13 in the first direction X and the insulating member 3 in the third direction Z is denoted as *b.* A size of a part of the laminate 1, covered by the insulating member 3 in the third direction Z, in the first direction X is denoted as c.

In the embodiment as shown in FIG. 6, by disposing the insulating member 3 between the border frame 2 and the laminate 1, the creepage distance *W* may be equal to *a+b+c.* That is, in some cases, W= *a+b+c.* This is beneficial for increasing the creepage distance of the photovoltaic module and improving the performance of the photovoltaic module.

Additionally, a distance between the cell layer and the edge of the laminate in the first direction X perpendicular to the third direction Z is greater than or equal to 2.8 mm and less than or equal to 20 mm. Exemplarily, the distance between the cell layer and the edge of the laminate may be 2.8 mm, 3.8 mm, 4.8 mm, 5.8 mm, 6.8 mm, 7.8 mm, 8.8 mm, 9.8 mm, 10.8 mm, 11.8 mm, 12.8 mm, 13.8 mm, 14.8 mm, 15.8 mm, 16.8 mm, 17.8 mm, 18.8 mm, 19.8 mm, 20 mm, etc.

If the distance between the cell layer and the edge of the laminate is relatively small, the creepage distance would be relatively small, posing a risk of the creepage distance being less than 10.4 mm.

If the distance between the cell layer and the edge of the laminate is relatively large, the size of the cell layer would be relatively small, so that less cell pieces would be provided, resulting in low output power of the photovoltaic module.

Therefore, the distance between the cell layer and the edge of the laminate in a range of greater than or equal to 2.8 mm and less than or equal to 20 mm not only can increase the creepage distance to improve the performance of the photovoltaic module, but also facilitates an increase in the number of cell pieces to increase the output power of the photovoltaic module.

The arrangement of the cell layer will be discussed in detail below in conjunction with several structures of the insulating member.

FIG. 7 is a schematic view of a connection structure between the laminate and the insulating member in some embodiments, with the outer edge of the laminate indicated by dashed lines. As shown in FIG. 7, in a plane perpendicular to the third direction Z, the laminate 1 includes at least a first sidewall 14, a second sidewall 15, a third sidewall 16, and a fourth sidewall 17 that are arranged in a peripheral direction thereof. As shown in FIG. 7, the insulating member 3 includes at least a first side portion 31, a second side portion 32, a third side portion 33, and a fourth side portion 34. The first side portion 31 is in contact with the first sidewall 14, the second side portion 32 is in contact with the second sidewall 15, the third side portion 33 is in contact with the third sidewall 16, and the fourth side portion 34 is in contact with the fourth sidewall 17.

In some embodiments, as shown in FIG. 7, the first side portion 31, the second side portion 32, the third side portion 33, and the fourth side portion 34 are constructed as an integrated structure.

In the assembling process of the photovoltaic module, one end of the entire insulating member 3 is attached to the edge of the laminate 1, and then the insulating member 3 is pulled along the edge of the laminate 1 to completely wrap around it in a full circle, completing the attachment of the insulating member 3 to a surface of the laminate 1 and reducing the attachment difficulty.

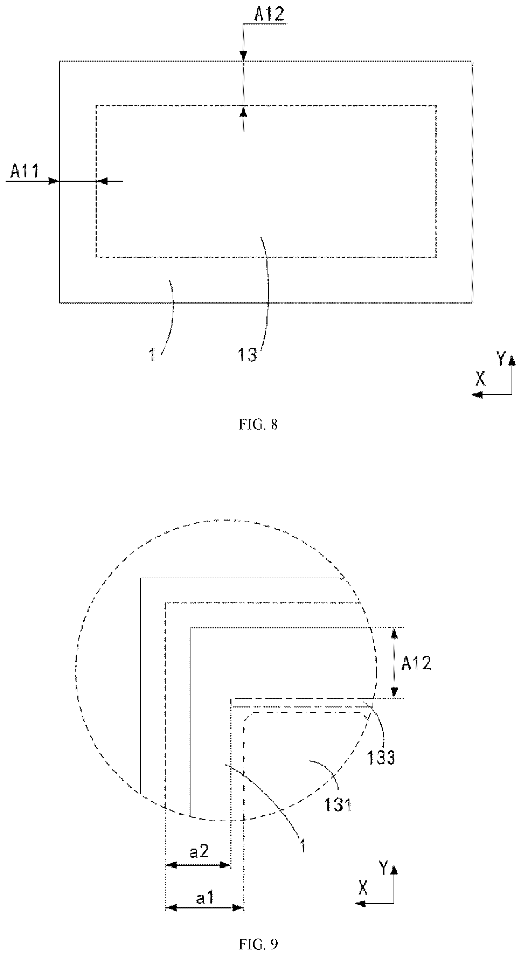

Based on the structure shown in FIG. 7, FIG. 8 is a schematic view illustrating a position of the cell layer of the laminate in FIG. 7, with an outer edge of the cell layer indicated by dashed lines. As shown in FIG. 8, a distance between the cell layer 13 and the edge of the laminate 1 in the first direction X ranges from 6 mm to 10 mm. The distance between the cell layer 13 and the edge of the laminate 1 in the first direction X is denoted as *All,* then 6 mm ≤ *A11* ≤ 10 mm. A distance between the cell layer and the edge of the laminate in the second direction Y ranges from 8 mm to 10 mm. The distance between the cell layer and the edge of the laminate in the second direction Y is denoted as *A12,* then 8 mm ≤ *A12* ≤ 10 mm.

*All* and *A12* may be equal or unequal.

Exemplarily, the distance between the cell layer 13 and the edge of the laminate 1 in the first direction X may be 6 mm, 6.5 mm, 7 mm, 7.5 mm, 8 mm, 8.2 mm, 8.4 mm, 8.6 mm, 8.8 mm, 9 mm, 9.2 mm, 9.4 mm, 9.6 mm, 9.8 mm, 10 mm, etc.

If the distance between the cell layer 13 and the edge of the laminate 1 in the first direction X is relatively small, then the distance between the cell layer 13 and the insulating member would be relatively small, posing a risk of the creepage distance being less than 10.4 mm.

If the distance between the cell layer 13 and the edge of the laminate 1 in the first direction X is relatively large, then the size of the cell layer 13 in the first direction X would be relatively small, so that less cell pieces would be provided, which may affect the output power of the photovoltaic module.

Therefore, with 6 mm ≤ *A11* ≤ 10 mm, not only the creepage distance of the photovoltaic module can be increased to improve the performance of the photovoltaic module, but also it is beneficial for increasing the number of cell pieces arranged in the first direction X to increase the output power of the photovoltaic module.

Exemplarily, 6 mm ≤ *A11* ≤ 7 mm. The distance between the cell layer 13 and the edge of the laminate 1 in the first direction X may be 6 mm, 6.1 mm, 6.2 mm, 6.3 mm, 6.4 mm, 6.5 mm, 6.6 mm, 6.7 mm, 6.8 mm, 6.9 mm, 7 mm, etc.

Exemplarily, 7 mm ≤ *A11* ≤ 8 mm. The distance between the cell layer 13 and the edge of the laminate 1 in the first direction X may be 7 mm, 7.1 mm, 7.2 mm, 7.3 mm, 7.4 mm, 7.5 mm, 7.6 mm, 7.7 mm, 7.8 mm, 7.9 mm, 8 mm, etc.

Exemplarily, 8 mm ≤ *A11* ≤ 9 mm. The distance between the cell layer 13 and the edge of the laminate 1 in the first direction X may be 8 mm, 8.1 mm, 8.2 mm, 8.3 mm, 8.4 mm, 8.5 mm, 8.6 mm, 8.7 mm, 8.8 mm, 8.9 mm, 9 mm, etc.

Exemplarily, 9 mm ≤ *A11* ≤ 10 mm. The distance between the cell layer 13 and the edge of the laminate 1 in the first direction X may be 9 mm, 9.1 mm, 9.2 mm, 9.3 mm, 9.4 mm, 9.5 mm, 9.6 mm, 9.7 mm, 9.8 mm, 9.9 mm, 10 mm, etc.

The distance between the cell layer 13 and the edge of the laminate 1 in the second direction Y may be 8 mm, 8.2 mm, 8.4 mm, 8.6 mm, 8.8 mm, 9 mm, 9.2 mm, 9.4 mm, 9.6 mm, 9.8 mm, 10 mm, etc.

If the distance between the cell layer 13 and the edge of the laminate 1 in the second direction Y is relatively small, then the distance between the cell layer 13 and the insulating member would be relatively small, posing a risk of the creepage distance being less than 10.4 mm.

If the distance between the cell layer 13 and the edge of the laminate 1 in the second direction Y is relatively large, then the size of the cell layer 13 in the second direction Y would be relatively small, so that less cell pieces would be provided, which may affect the output power of the photovoltaic module.

Therefore, with 8 mm ≤ *A12* ≤ 10 mm, not only the creepage distance of the photovoltaic module can be increased to improve the performance of the photovoltaic module, and but also it is beneficial for increasing the number of cell pieces arranged in the second direction Y to increase the output power of the photovoltaic module.

Exemplarily, 8 mm ≤ *A12* ≤ 9 mm. The distance between the cell layer 13 and the edge of the laminate 1 in the second direction Y may be 8 mm, 8.1 mm, 8.2 mm, 8.3 mm, 8.4 mm, 8.5 mm, 8.6 mm, 8.7 mm, 8.8 mm, 8.9 mm, 9 mm, etc.

Exemplarily, 9 mm ≤ *A12* ≤ 10 mm. The distance between the cell layer 13 and the edge of the laminate 1 in the second direction Y may be 9 mm, 9.1 mm, 9.2 mm, 9.3 mm, 9.4 mm, 9.5 mm, 9.6 mm, 9.7 mm, 9.8 mm, 9.9 mm, 10 mm, etc.

Based on the structure shown in FIG. 8, FIG. 9 is a schematic structural view of the cell layer in FIG. 8 in some embodiments. As shown in FIG. 9, the cell layer 13 includes a plurality of cell pieces 131 and at least one busbar 133. The plurality of cell pieces 131 are arranged and connected in the first direction X to form a cell string. The busbar 133 extends in the first direction X. At least part of the busbar 133 is located between the cell string and the edge of the laminate 1 in the second direction Y. The busbar 133 is configured to electrically connecting adjacent cell strings.

A distance between an outermost cell piece 131 and the edge of the laminate 1 in the first direction X is denoted as *a1,* and 8 mm ≤ *a1* ≤ 10 mm. Exemplarily, the distance *a1* between the outermost cell piece 131 and the edge of the laminate 1 in the first direction X may be 8 mm, 8.2 mm, 8.4 mm, 8.6 mm, 8.8 mm, 9 mm, 9.2 mm, 9.4 mm, 9.6 mm, 9.8 mm, 10 mm, etc.

With 8 mm ≤ *a1* ≤ 10 mm, not only the creepage distance of the photovoltaic module can be increased to improve the performance of the photovoltaic module, but also it is beneficial for increasing the number of cell pieces to increase the output power of the photovoltaic module.

Exemplarily, 8 mm ≤ *a1* ≤ 9 mm. The distance *a1* between the outermost cell piece 131 and the edge of the laminate 1 in the first direction X may be 8 mm, 8.1 mm, 8.2 mm, 8.3 mm, 8.4 mm, 8.5 mm, 8.6 mm, 8.7 mm, 8.8 mm, 8.9 mm, 9 mm, etc.

Exemplarily, 9 mm ≤ *a1* ≤ 10 mm. The distance *a1* between the outermost cell piece 131 and the edge of the laminate 1 in the first direction X may be 9 mm, 9.1 mm, 9.2 mm, 9.3 mm, 9.4 mm, 9.5 mm, 9.6 mm, 9.7 mm, 9.8 mm, 9.9 mm, 10 mm, etc.

As shown in FIG. 9, a distance between the busbar 133 and the edge of the laminate 1 in the first direction X is denoted as *a2.* In some embodiments, *a2 < a1,* and in this case, *a2 = All,* and 0.5mm ≤ *a1-a2* ≤ 2mm. Exemplarily, a value of *a1-a2* may be equal to 0.5 mm, 0.55 mm, 0.6 mm, 0.65 mm, 0.7 mm, 0.75 mm, 0.8 mm, 0.85 mm, 0.9 mm, 0.95 mm, 1 mm, 1.05 mm, 1.1 mm, 1.15 mm, 1.2 mm, 1.25 mm, 1.3 mm, 1.35 mm, 1.4 mm, 1.45 mm, 1.5 mm, 1.55 mm, 1.6 mm, 1.65 mm, 1.7 mm, 1.75 mm, 1.8 mm, 1.85 mm, 1.9 mm, 1.95 mm, 2 mm, etc.

If the value of *a1-a2* is relatively small, then a length of the busbar 133 would be relatively large, resulting in higher costs of the busbar 133, and the distance between the busbar 133 and the edge of the laminate 1 would be relatively small, causing the creepage distance of the photovoltaic module to be relatively small.

If the value of *a1-a2* is relatively large, then the length of the busbar 133 would be relatively small, leading to poor current transmission capability of the busbar 133 and a high risk of low output power of the photovoltaic module.

Therefore, with 0.5 mm ≤ *a1-a2* ≤ 2 mm, not only the cost of the busbar 133 can be reduced, and the creepage distance of the photovoltaic module can be increased to improve the performance of the photovoltaic module, but also the current transmission capability of the busbar 133 can be enhanced to improve the output power of the photovoltaic module.

Exemplarily, 0.5mm ≤ *a1-a2* ≤ 1mm. The value of *a1-a2* may be equal to 0.5 mm, 0.52 mm, 0.54 mm, 0.56 mm, 0.58 mm, 0.6 mm, 0.62 mm, 0.64 mm, 0.66 mm, 0.68 mm, 0.7 mm, 0.72 mm, 0.74 mm, 0.76 mm, 0.78 mm, 0.8 mm, 0.82 mm, 0.84 mm, 0.86 mm, 0.88 mm, 0.9 mm, 0.92 mm, 0.94 mm, 0.96 mm, 0.98 mm, 1 mm, etc.

Exemplarily, 1 mm ≤ *a1-a2* ≤ 1.5 mm. The value of *a1-a2* may be equal to 1 mm, 1.02 mm, 1.04 mm, 1.06 mm, 1.08 mm, 1.1 mm, 1.12 mm, 1.14 mm, 1.16 mm, 1.18 mm, 1.2 mm, 1.22 mm, 1.24 mm, 1.26 mm, 1.28 mm, 1.3 mm, 1.32 mm, 1.34 mm, 1.36 mm, 1.38 mm, 1.4 mm, 1.42 mm, 1.44 mm, 1.46 mm, 1.48 mm, 1.5 mm, etc.

Exemplarily, 1.5 mm ≤ *a1-a2* ≤ 2 mm. The value of *a1-a2* may be equal to 1.5 mm, 1.52 mm, 1.54 mm, 1.56 mm, 1.58 mm, 1.6 mm, 1.62 mm, 1.64 mm, 1.66 mm, 1.68 mm, 1.7 mm, 1.72 mm, 1.74 mm, 1.76 mm, 1.78 mm, 1.8 mm, 1.82 mm, 1.84 mm, 1.86 mm, 1.88 mm, 1.9 mm, 1.92 mm, 1.94 mm, 1.96 mm, 1.98 mm, 2 mm, etc.

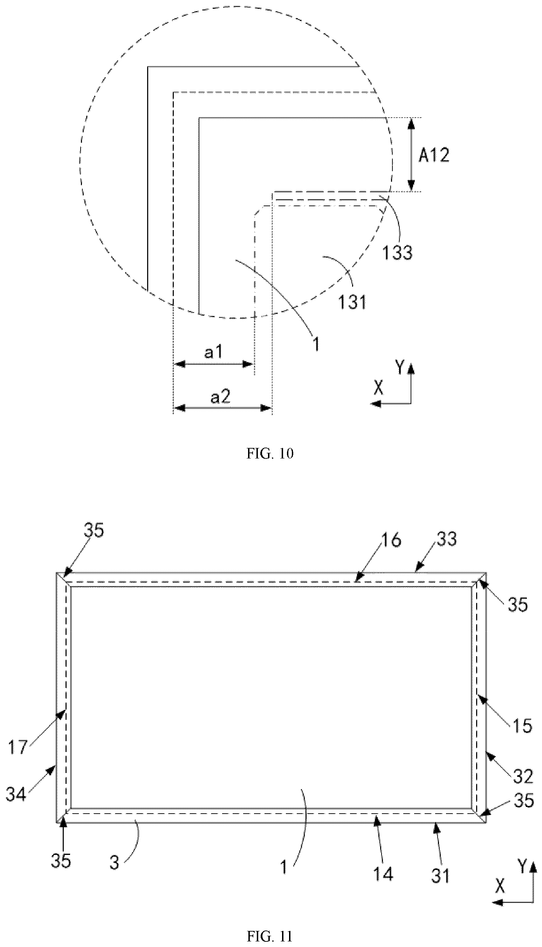

In some other embodiments, as shown in FIG. 10, *a2 > a1,* and in this case, *a1 = A11,* and 1 mm ≤ *a2-a1* ≤ 8 mm. Exemplarily, the value of *a2-a1* may be equal to 1 mm, 2 mm, 3 mm, 4 mm, 5 mm, 6 mm, 7 mm, 8 mm, etc.

If the value of *a2-a1* is relatively small, then *A21* would be relatively small, resulting in a relatively small creepage distance of the photovoltaic module.

If the value of *a2-a1* is relatively large, then the length of the busbar 133 would be relatively small, leading to poor current transmission capability of the busbar 133 and a high risk of low output power of the photovoltaic module.

Therefore, with 1 mm ≤ *a2-a1* ≤ 8 mm, not only the creepage distance of the photovoltaic module can be increased to improve the performance of the photovoltaic module, but also the current transmission capability of the busbar 133 can be enhanced to increase the output power of the photovoltaic module.

Exemplarily, 1 mm ≤ *a2-a1* ≤ 5 mm. The value of *a2-a1* may be equal to 1 mm, 1.5 mm, 2 mm, 2.5 mm, 3 mm, 3.5 mm, 4 mm, 4.5 mm, 5 mm, etc.

Exemplarily, 5 mm ≤ *a2-a1* ≤ 8 mm. The value of *a2-a1* may be equal to 5 mm, 5.5 mm, 6 mm, 6.5 mm, 7 mm, 7.5 mm, 8 mm, etc.

FIG. 11 is a schematic view of a connection structure between the laminate and the insulating member in some other embodiments. As shown in FIG. 11, the first side portion 31, the second side portion 32, the third side portion 33, and the fourth side portion 34 are constructed as a modular structure, with a joint gap 35 existing between adjacent side portions.

The joint gap 35 may be parallel to the first direction X or the second direction Y, or form an angle with both the first direction X and the second direction Y.

FIG. 11 illustrates an example where an extending direction of the joint gap 35 forms a 45-degree angle with both the first direction X and the second direction Y.

In the assembling process of the photovoltaic module, the insulating member 3 may first be cut into four pieces with bevel angles of 45 degrees according to preset sizes, and then the four pieces are attached to the four sidewalls of the laminate 1, respectively.

Alternatively, the entire insulating member 3 is first attached to the first sidewall 14 of the laminate 1 and then cut off. Then the remaining insulating member 3 is attached to the second sidewall 15 of the laminate 1 and cut off again. Then the remaining insulating member 3 is attached to the third sidewall 16 of the laminate 1 and cut off again. Then the remaining insulating member 3 is attached to the fourth sidewall 17 of the laminate 1 to complete the attachment of the insulating member 3 to all four sidewalls of the laminate 1.

In this embodiment, the insulating member 3 is first cut into four parts with specific sizes and angles, and then attached to the four sidewalls of the laminate 1, respectively, reducing the risk of wrinkles of the insulating member 3 at corners of the laminate 1 and improving the flatness of the attachment of the insulating member 3 on the surface of the laminate 1.

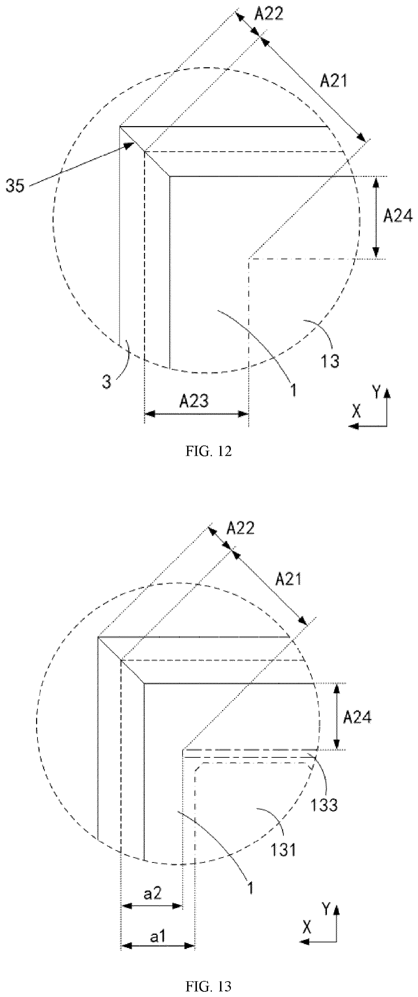

Based on the structure shown in FIG. 11, FIG. 12 is a schematic view of an arrangement position of the cell layer at the joint gap, with the outer edge of the laminate being indicated by "dashed lines" and the outer edge of the cell layer being indicated by "short dashes-dots". As shown in FIG. 12, a minimum distance between the cell layer 13 and the edge of the laminate 1 at the joint gap 35 is denoted as *A21.* At the joint gap 35, a distance between the edge of the laminate 1 and the outer edge of the insulating member 3 along the joint gap 35 is denoted as *A22.*

Referring to FIG. 6 and FIG.12 simultaneously, when *A21+A22* ≤ *a+b+c,* the creepage distance *W* of the photovoltaic module is equal to *A21+A22,* i.e., *W=A21+A22.* In this case, 2.8 mm ≤ *A21* ≤ 11.3 mm, and 0.1 mm ≤ *A22* ≤ 8.6 mm.

The minimum distance *A21* between the cell layer 13 and the edge of the laminate 1 at the joint gap 35 may be 2.8 mm, 3 mm, 3.3 mm, 3.6 mm, 3.9 mm, 4 mm, 4.3 mm, 4.6 mm, 4.9 mm, 5 mm, 5.3 mm, 5.6 mm, 5.9 mm, 6 mm, 6.3 mm, 6.6 mm, 6.9 mm, 7 mm, 7.3 mm, 7.6 mm, 7.9 mm, 8 mm, 8.3 mm, 8.8 mm, 8.9 mm, 9 mm, 9.3 mm, 9.6 mm, 9.9 mm, 10 mm, 10.3 mm, 10.6 mm, 10.9 mm, 11 mm, 11.3 mm, etc.

If *A21* is relatively small, then the creepage distance *W* of the photovoltaic module would be relatively small, posing a risk of the creepage distance being less than 10.4 mm, which adversely affects the performance of the photovoltaic module.

If A21 is relatively large, then the distance between the cell layer 13 and the edge of the laminate 1 would be relatively large, so that less cell pieces would be included in the cell layer 13, which adversely affects the output power of the photovoltaic module.

Therefore, with 2.8 mm ≤ *A21* ≤ 11.3 mm, not only the creepage distance of the photovoltaic module can be increased to improve the performance of the photovoltaic module, but also it is beneficial for increasing the number of cell pieces to increase the output power of the photovoltaic module.

Exemplarily, 2.8 mm ≤ *A21* ≤ 5.3 mm. The minimum distance A21 between the cell layer 13 and the edge of the laminate 1 at the joint gap 35 may be 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, etc.

Exemplarily, 5.3 mm ≤ *A21* ≤ 8.3 mm. The minimum distance *A21* between the cell layer 13 and the edge of the laminate 1 at the joint gap 35 may be 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, etc.

Exemplarily, 8.3 mm ≤ *A21* ≤ 11.3 mm. The minimum distance A21 between the cell layer 13 and the edge of the laminate 1 at the joint gap 35 may be 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 10 mm, 10.1 mm, 10.2 mm, 10.3 mm, 10.4 mm, 10.5 mm, 10.6 mm, 10.7 mm, 10.8 mm, 10.9 mm, 11 mm, 11.1 mm, 11.2 mm, 11.3 mm, etc.

At the joint gap 35, the distance *A22* between the edge of the laminate 1 and the outer edge of the insulating member 3 along the joint gap 35 may be 0.1 mm, 0.6 mm, 1.1 mm, 1.6 mm, 2.1 mm, 2.6 mm, 3.1 mm, 3.6 mm, 4.1 mm, 4.6 mm, 5.1 mm, 5.6 mm, 6.1 mm, 6.6 mm, 7.1 mm, 7.6 mm, 8.1 mm, 8.6 mm, etc.

If *A22* is relatively small, then the creepage distance *W* of the photovoltaic module would be relatively small, posing a risk of the creepage distance being less than 10.4 mm, which adversely affects the performance of the photovoltaic module. Moreover, if *A22* is relatively small, the thickness of the insulating member 3 would be relatively thin, making it more difficult to process the insulating member 3 and increasing the risk of damage to the insulating member 3 during processing, installation, transportation, etc., indicating poor structural strength of the insulating member 3.

If *A22* is relatively large, then the thickness of the insulating member 3 would be relatively large, resulting in higher costs of the insulating member 3.

Therefore, with 0.1 mm ≤ *A22* ≤ 8.6 mm, not only the creepage distance of the photovoltaic module can be increased to improve the performance of the photovoltaic module, but also the structural strength of the insulating member 3 can be enhanced, and the costs of the insulating member 3 can be reduced, thereby reducing the costs of the photovoltaic module.

Exemplarily, 0.1 mm ≤ *A22 ≤* 2.6 mm. At the joint gap 35, the distance *A22* between the edge of the laminate 1 and the outer edge of the insulating member 3 along the joint gap 35 may be 0.1 mm, 0.2 mm, 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2.0 mm, 2.1 mm, 2.2 mm, 2.3 mm, 2.4 mm, 2.5 mm, 2.6 mm, etc.

Exemplarily, 2.6 mm ≤ *A22* ≤ 4.6 mm. At the joint gap 35, the distance *A22* between the edge of the laminate 1 and the outer edge of the insulating member 3 along the joint gap 35 may be 2.6 mm, 2.7 mm, 2.8 mm, 2.9 mm, 3.0 mm, 3.1 mm, 3.2 mm, 3.3 mm, 3.4 mm, 3.5 mm, 3.6 mm, 3.7 mm, 3.8 mm, 3.9 mm, 4.0 mm, 4.1 mm, 4.2 mm, 4.3 mm, 4.4 mm, 4.5 mm, 4.6 mm, etc.

Exemplarily, 4.6 mm ≤ *A22* ≤ 6.6 mm. At the joint gap 35, the distance *A22* between the edge of the laminate 1 and the outer edge of the insulating member 3 along the joint gap 35 may be 4.6 mm, 4.7 mm, 4.8 mm, 4.9 mm, 5.0 mm, 5.1 mm, 5.2 mm, 5.3 mm, 5.4 mm, 5.5 mm, 5.6 mm, 5.7 mm, 5.8 mm, 5.9 mm, 6.0 mm, 6.1 mm, 6.2 mm, 6.3 mm, 6.4 mm, 6.5 mm, 6.6 mm, etc.

Exemplarily, 6.6 mm ≤ *A22* ≤ 8.6 mm. At the joint gap 35, the distance *A22* between the edge of the laminate 1 and the outer edge of the insulating member 3 along the joint gap 35 may be 6.6 mm, 6.7 mm, 6.8 mm, 6.9 mm, 7.0 mm, 7.1 mm, 7.2 mm, 7.3 mm, 7.4 mm, 7.5 mm, 7.6 mm, 7.7 mm, 7.8 mm, 7.9 mm, 8.0 mm, 8.1 mm, 8.2 mm, 8.3 mm, 8.4 mm, 8.5 mm, 8.6 mm, etc.

Continuing to refer to FIG. 12, a distance between the cell layer 13 and the edge of the laminate 1 in the first direction X is denoted as *A23,* and 6 mm ≤ *A23* ≤ 10 mm. A distance between the cell layer 13 and the edge of the laminate 1 in the second direction Y is denoted as *A24,* and 8 mm ≤ *A24* ≤ 10 mm.

Exemplarily, the distance *A23* between the cell layer 13 and the edge of the laminate 1 in the first direction X may be 6 mm, 6.5 mm, 7 mm, 7.5 mm, 8 mm, 8.5 mm, 9 mm, 9.5 mm, 10 mm, etc.

If the distance between the cell layer 13 and the edge of the laminate 1 in the first direction X is relatively small, then the creepage distance *W* of the photovoltaic module would be relatively small, posing a risk of the creepage distance being less than 10.4 mm, which adversely affects the performance of the photovoltaic module.

If the distance between the cell layer 13 and the edge of the laminate 1 in the first direction X is relatively large, then less cell pieces would be included in the cell layer 13, which adversely affects the output power of the photovoltaic module.

Therefore, with 6 mm ≤ *A23* ≤ 10 mm, not only the creepage distance of the photovoltaic module can be increased to improve the performance of the photovoltaic module, but also it is beneficial for increasing the number of cell pieces to increase the output power of the photovoltaic module.

Exemplarily, 6 mm ≤ *A23* ≤ 8 mm. The distance *A23* between the cell layer 13 and the edge of the laminate 1 in the first direction X may be 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, etc.

Exemplarily, 8 mm ≤ *A23* ≤ 10 mm. The distance A23 between the cell layer 13 and the edge of the laminate 1 in the first direction X may be 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 10 mm, etc.

The distance *A24* between the cell layer 13 and the edge of the laminate 1 in the second direction Y may be 8 mm, 8.5 mm, 9 mm, 9.5 mm, 10 mm, etc.

If the distance between the cell layer 13 and the edge of the laminate 1 in the second direction Y is relatively small, then the creepage distance *W* of the photovoltaic module would be relatively small, posing a risk of the creepage distance being less than 10.4 mm, which adversely affects the performance of the photovoltaic module.

If the distance between the cell layer 13 and the edge of the laminate 1 in the second direction Y is relatively large, then less cell pieces would be included in the cell layer 13, which adversely affects the output power of the photovoltaic module.

Therefore, with 8 mm ≤ *A24* ≤ 10 mm, not only the creepage distance of the photovoltaic module can be increased to improve the performance of the photovoltaic module, but also it is beneficial for increasing the number of cell pieces to increase the output power of the photovoltaic module.

Exemplarily, 8 mm ≤ *A24* ≤ 9 mm. The distance *A24* between the cell layer 13 and the edge of the laminate 1 in the second direction Y may be 8.0 mm, 8.1 mm, 8.2 mm, 8.3 mm, 8.4 mm, 8.5 mm, 8.6 mm, 8.7 mm, 8.8 mm, 8.9 mm, 9.0 mm, etc.

Exemplarily, 9 mm ≤ *A24* ≤ 10 mm, the distance *A24* between the cell layer 13 and the edge of the laminate 1 in the second direction Y may be 9.0 mm, 9.1 mm, 9.2 mm, 9.3 mm, 9.4 mm, 9.5 mm, 9.6 mm, 9.7 mm, 9.8 mm, 9.9 mm, 10.0 mm, etc.

FIG. 13 is a schematic structural view of the cell layer in FIG.12 in some embodiments. As shown in FIG. 13, a distance between the outermost cell piece 131 and the edge of the laminate 1 in the first direction X is defined as *a1,* and 8 mm ≤ *a1* ≤ 10 mm.

As shown in FIG. 13, a distance between the busbar 133 and the edge of the laminate 1 in the first direction X is defined as *a2.* In some embodiments, *a2 < a1,* and in this case, *a2 = A23*, and 0.5mm ≤ *a1-a2* ≤ 2mm*.*

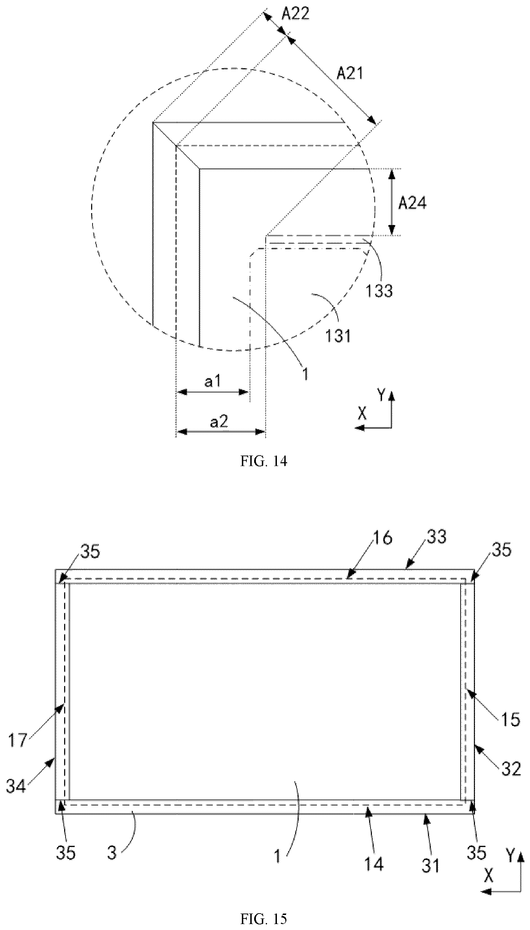

In some other embodiments, as shown in FIG. 14, *a2 > a1*, and in this case, *a1 = A23*, and 1 mm ≤ *a2-a1* ≤ 8 mm.

FIG. 15 is a schematic view of a connection structure between the laminate and the insulating member in yet other embodiments. As shown in FIG. 15, the joint gap 35 is parallel to the first direction X or the second direction Y. FIG. 15 illustrates an example where the joint gap 35 is parallel to the first direction X.

In this case, a method for attaching the insulating member 3 to the edge of the laminate 1 is the same as that of the structure in FIG. 11, and details are not described herein.

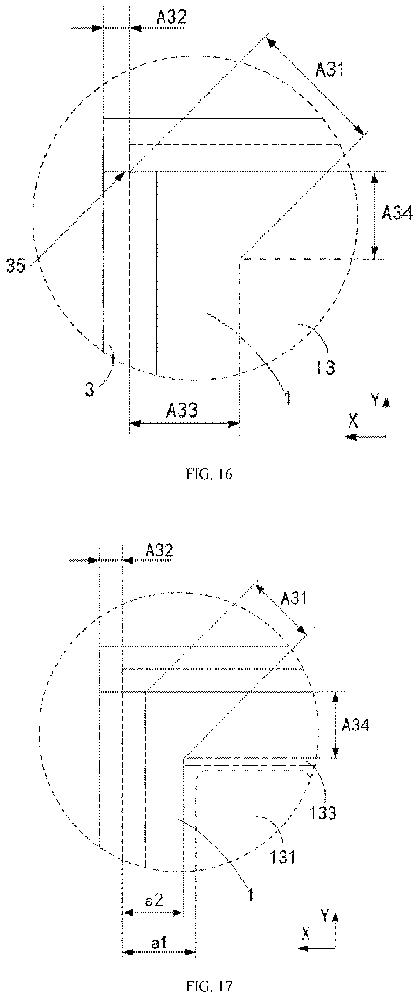

Based on the structure shown in FIG. 15, FIG. 16 is a schematic view of an arrangement position of the cell layer at the joint gap. As shown in FIG. 16, a minimum distance between the cell layer 13 and the edge of the laminate 1 at the joint gap 35 is denoted as *A31.* At the joint gap 35, a distance between the edge of the laminate 1 and the outer edge of the insulating member 3 along the joint gap 35 is denoted as *A32.*

Referring to FIG. 6 and FIG.16 simultaneously, when *A31*+*A32* ≤ *a+b+c,* the creepage distance *W* of the photovoltaic module is equal to *A31+A32,* i.e., *W = A31+A32.* In this case, 10.5 mm ≤ *A31* ≤ 20 mm, and 0.3 mm ≤ *A32* ≤ 0.5 mm.

The minimum distance *A31* between the cell layer 13 and the edge of the laminate 1 at the joint gap 35 may be 10.5 mm, 11 mm, 11.5 mm, 12 mm, 12.5 mm, 13 mm, 13.5 mm, 14 mm, 14.5 mm, 15 mm, 15.5 mm, 16 mm, 16.5 mm, 17 mm, 17.5 mm, 18 mm, 18.5 mm, 19 mm, 19.5 mm, 20 mm, etc.

If *A31* is relatively small, then the creepage distance *W* of the photovoltaic module would be relatively small, posing a risk of the creepage distance being less than 10.4 mm, which adversely affects the performance of the photovoltaic module.

If *A31* is relatively large, then the distance between the cell layer 13 and the edge of the laminate 1 would be relatively large, so that less cell pieces would be included in the cell layer 13, which adversely affects the output power of the photovoltaic module.

Therefore, with 10.5 mm ≤ *A31* ≤ 20 mm, not only the creepage distance of the photovoltaic module can be increased to improve the performance of the photovoltaic module, but also it is beneficial for increasing the number of cell pieces to increase the output power of the photovoltaic module.

Exemplarily, 10.5 mm ≤ *A31* ≤ 15 mm. The minimum distance *A31* between the cell layer 13 and the edge of the laminate 1 at the joint gap 35 may be 10.5 mm, 10.6 mm, 10.7 mm, 10.8 mm, 10.9 mm, 11.0 mm, 11.1 mm, 11.2 mm, 11.3 mm, 11.4 mm, 11.5 mm, 11.6 mm, 11.7 mm, 11.8 mm, 11.9 mm, 12.0 mm, 12.1 mm, 12.2 mm, 12.3 mm, 12.4 mm, 12.5 mm, 12.6 mm, 12.7 mm, 12.8 mm, 12.9 mm, 13.0 mm, 13.1 mm, 13.2 mm, 13.3 mm, 13.4 mm, 13.5 mm, 13.6 mm, 13.7 mm, 13.8 mm, 13.9 mm, 14.0 mm, 14.1 mm, 14.2 mm, 14.3 mm, 14.4 mm, 14.5 mm, 14.6 mm, 14.7 mm, 14.8 mm, 14.9 mm, 15.0 mm, etc.

Exemplarily, 15 mm ≤ *A31* ≤ 20 mm. The minimum distance A31 between the cell layer 13 and the edge of the laminate 1 at the joint gap 35 may be 15.0 mm, 15.1 mm, 15.2 mm, 15.3 mm, 15.4 mm, 15.5 mm, 15.6 mm, 15.7 mm, 15.8 mm, 15.9 mm, 16.0 mm, 16.1 mm, 16.2 mm, 16.3 mm, 16.4 mm, 16.5 mm, 16.6 mm, 16.7 mm, 16.8 mm, 16.9 mm, 17.0 mm, 17.1 mm, 17.2 mm, 17.3 mm, 17.4 mm, 17.5 mm, 17.6 mm, 17.7 mm, 17.8 mm, 17.9 mm, 18.0 mm, 18.1 mm, 18.2 mm, 18.3 mm, 18.4 mm, 18.5 mm, 18.6 mm, 18.7 mm, 18.8 mm, 18.9 mm, 19.0 mm, 19.1 mm, 19.2 mm, 19.3 mm, 19.4 mm, 19.5 mm, 19.6 mm, 19.7 mm, 19.8 mm, 19.9 mm, 20.0 mm, etc.

At the joint gap 35, the distance *A32* between the edge of the laminate 1 and the outer edge of the insulating member 3 along the joint gap 35 may be 0.3 mm, 0.32 mm, 0.34 mm, 0.36 mm, 0.38 mm, 0.4 mm, 0.42 mm, 0.44 mm, 0.46 mm, 0.48 mm, 0.5 mm, etc.

If *A32* is relatively small, then the creepage distance *W* of the photovoltaic module would be relatively small, posing a risk of the creepage distance being less than 10.4 mm, which adversely affects the performance of the photovoltaic module. Moreover, if A32 is relatively small, then the thickness of the insulating member 3 would be relatively thin, making it more difficult to process the insulating member 3 and increasing the risk of damage to the insulating member 3 during processing, installation, transportation, etc., indicating poor structural strength of the insulating member 3.

If *A32* is relatively large, the thickness of the insulating member 3 would be relatively large, resulting in higher costs for the insulating member 3.

Therefore, with 0.3 mm ≤ *A32* ≤ 0.5 mm, not only the creepage distance of the photovoltaic module can be increased to improve the performance of the photovoltaic module, but also the structural strength of the insulating member 3 can be enhanced, and the costs of the insulating member 3 can be reduced, thereby reducing the costs of the photovoltaic module.

Exemplarily, 0.3 mm ≤ *A32* ≤ 0.4 mm. At the joint gap 35, the distance *A32* between the edge of the laminate 1 and the outer edge of the insulating member 3 along the joint gap 35 may be 0.3 mm, 0.31 mm, 0.32 mm, 0.33 mm, 0.34 mm, 0.35 mm, 0.36 mm, 0.37 mm, 0.38 mm, 0.39 mm, 0.4 mm, etc.

Exemplarily, 0.4 mm ≤ *A32* ≤ 0.5 mm. At the joint gap 35, the distance *A32* between the edge of the laminate 1 and the outer edge of the insulating member 3 along the joint gap 35 may be 0.4 mm, 0.41 mm, 0.42 mm, 0.43 mm, 0.44 mm, 0.45 mm, 0.46 mm, 0.47 mm, 0.48 mm, 0.49 mm, 0.5 mm, etc.

Continuing to refer to FIG. 16, a distance between the cell layer 13 and the edge of the laminate 1 in the first direction X is denoted as *A33,* and 6 mm ≤ *A33* ≤ 10 mm. A distance between the cell layer 13 and the edge of the laminate 1 in the second direction Y is denoted as *A34,* and 8 mm ≤ *A34* ≤ 10 mm.

Exemplarily, the distance *A33* between the cell layer 13 and the edge of the laminate 1 in the first direction X may be 6 mm, 6.5 mm, 7 mm, 7.5 mm, 8 mm, 8.5 mm, 9 mm, 9.5 mm, 10 mm, etc.

If the distance between the cell layer 13 and the edge of the laminate 1 in the first direction X is relatively small, then the creepage distance *W* of the photovoltaic module would be relatively small, posing a risk of the creepage distance being less than 10.4 mm, which adversely affects the performance of the photovoltaic module.

If the distance between the cell layer 13 and the edge of the laminate 1 in the first direction X is relatively large, then less cell pieces would be included in the cell layer 13, which adversely affects the output power of the photovoltaic module.

Therefore, with 6 mm ≤ *A33* ≤ 10 mm, not only the creepage distance of the photovoltaic module can be increased to improve the performance of the photovoltaic module, but also it is beneficial for increasing the number of cell pieces to increase the output power of the photovoltaic module.

Exemplarily, 6 mm ≤ *A33* ≤ 8 mm. The distance *A33* between the cell layer 13 and the edge of the laminate 1 in the first direction X may be 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, etc.

Exemplarily, 8 mm ≤ *A33* ≤ 10 mm. The distance *A33* between the cell layer 13 and the edge of the laminate 1 in the first direction X may be 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 10 mm, etc.

The distance *A34* between the cell layer 13 and the edge of the laminate 1 in the second direction Y may be 8 mm, 8.2 mm, 8.4 mm, 8.6 mm, 8.8 mm, 9 mm, 9.2 mm, 9.4 mm, 9.6 mm, 9.8 mm, 10 mm, etc.

If the distance between the cell layer 13 and the edge of the laminate 1 in the second direction Y is relatively small, then the creepage distance *W* of the photovoltaic module would be relatively small, posing a risk of the creepage distance being less than 10.4 mm, which adversely affects the performance of the photovoltaic module.

If the distance between the cell layer 13 and the edge of the laminate 1 in the second direction Y is relatively large, then less cell pieces would be included in the cell layer 13, which adversely affects the output power of the photovoltaic module.

Therefore, with 8 mm ≤ *A34* ≤ 10 mm, not only the creepage distance of the photovoltaic module can be increased to improve the performance of the photovoltaic module, but also it is beneficial for increasing the number of cell pieces to increase the output power of the photovoltaic module.

Exemplarily, 8 mm ≤ *A34* ≤ 9 mm. The distance *A34* between the cell layer 13 and the edge of the laminate 1 in the second direction Y may be 8mm, 8.1 mm, 8.2 mm, 8.3 mm, 8.4 mm, 8.5 mm, 8.6 mm, 8.7 mm, 8.8 mm, 8.9 mm, 9 mm, etc.

Exemplarily, 9 mm ≤ *A34* ≤ 10 mm. The distance *A34* between the cell layer 13 and the edge of the laminate 1 in the second direction Y may be 9 mm, 9.1 mm, 9.2 mm, 9.3 mm, 9.4 mm, 9.5 mm, 9.6 mm, 9.7 mm, 9.8 mm, 9.9 mm, 10 mm, etc.

FIG. 17 is a schematic structural view of the cell layer in FIG.16 in some embodiments. As shown in FIG. 17, a distance between the outermost cell piece 131 and the edge of the laminate 1 in the first direction X is denoted as *a1,* and a distance between the busbar 133 and the edge of the laminate 1 in the first direction X is denoted as *a2.* In some embodiments, as shown in FIG. 17, *a2 < a1,* and in this case, *a2 = A33.* A distance between the busbar 133 and the edge of the laminate 1 at the joint gap 35 is denoted as *A31,* and 10.5 *mm* ≤ *A31* ≤ 15 mm.

When *a2 < a1,* 0.5 mm ≤ *a1-a2* ≤ 2 mm.

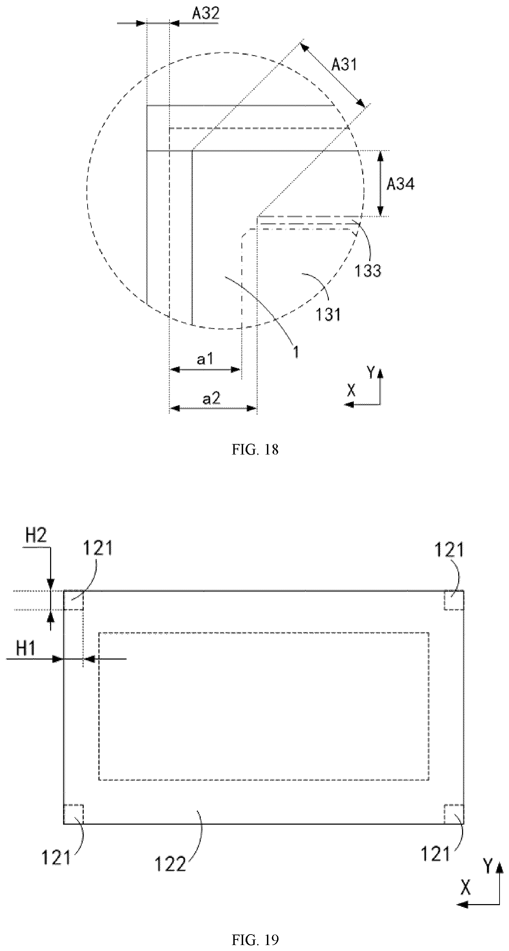

FIG. 18 is a schematic structural view of the cell layer in FIG.16 in some embodiments. As shown in FIG. 18, *a2 > a1,* and 1 mm ≤ *a2-a1* ≤ 8 mm, and in this case, *a1 = A33.*

FIG. 19 is a schematic structural view of the laminate in some embodiments. As shown in FIG. 19, the encapsulation layer 12 includes at least a first adhesive film 121. In the thickness direction Z of the laminate, a projection of the joint gap is within a projection of the first adhesive film 121. The first adhesive film 121 is a waterproof adhesive film. Exemplarily, the first adhesive film 121 is made of butyl rubber.

In this embodiment, disposing a waterproof adhesive film under the joint gap can reduce the risk of external moisture entering an interior of the laminate through the joint gap, thereby reducing the risks of aging and short-circuiting of the cell pieces caused by moisture intrusion, improving the performance of the photovoltaic module, and prolonging the service life of the photovoltaic module.

As shown in FIG. 19, the encapsulation layer 12 further includes a second adhesive film 122. The first adhesive film 121 is positioned at least at the joint gap, while the second adhesive film 122, which does not have the waterproof property, may be positioned at other regions to reduce the costs of the encapsulation layer 12.

The projection of the first adhesive film 121 in the third direction Z may be fan-shaped, triangular, rectangular, L-shaped, concentric-square-shaped, or in other shapes. In the embodiments of the present application, the shape of the first adhesive film 121 is not particularly limited.

FIG. 19 illustrates an example where the projection of the first adhesive film 121 in the third direction Z is rectangular.

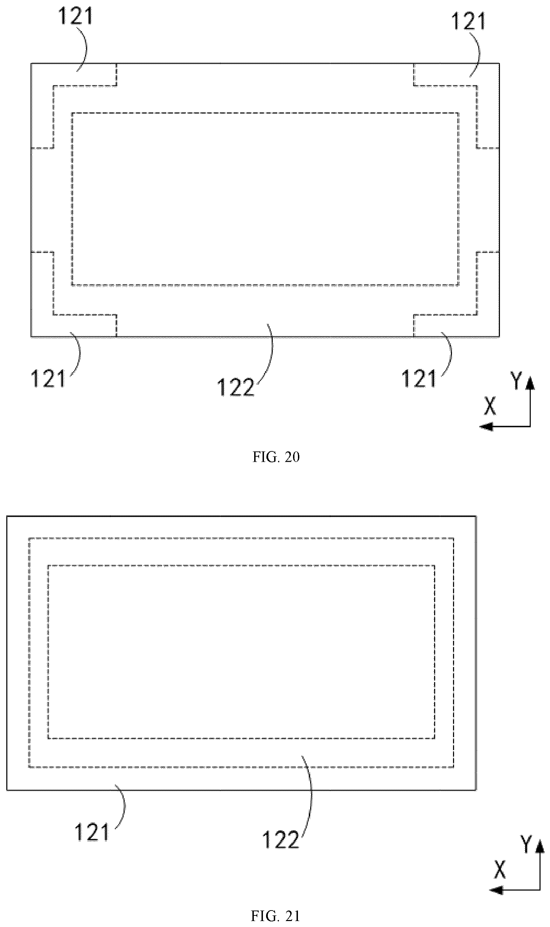

FIG. 20 is a schematic structural view of the laminate in some other embodiments. FIG. 20 illustrates an example where the projection of the first adhesive film 121 in the third direction Z is L-shaped.

FIG. 21 is a schematic structural view of the laminate in yet other embodiments. FIG. 21 illustrates an example where the projection of the first adhesive film 121 in the third direction Z is concentric-square-shaped.

Referring to FIG. 19 again, a size of the first adhesive film 121 in the first direction X is denoted as *H1,* and 10 mm ≤ *H1* ≤ 100 mm. Exemplarily, the size of the first adhesive film 121 in the first direction X may be 10 mm, 20 mm, 30 mm, 40 mm, 50 mm, 60 mm, 70 mm, 80 mm, 90 mm, 100 mm, etc.

If the size of the first adhesive film 121 in the first direction X is relatively small, then the shielding effect of the first adhesive film 121 on the joint gap would be relatively poor, leading to higher risk of moisture intrusion into the laminate.

If the size of the first adhesive film 121 in the first direction X is relatively large, then the material costs of the first adhesive film 121 would be relatively high.

Therefore, with 10 mm ≤ *H1* ≤ 100 mm, not only the shielding effect of the first adhesive film 121 on the joint gap can be improved to reduce the risk of moisture intrusion into the laminate, thereby reducing the risks such as aging and short-circuiting of the cell pieces, improving the performance of the photovoltaic module, and prolonging the service life of the photovoltaic module, but also the material costs of the first adhesive film 121 can be reduced, thereby reducing the costs of the photovoltaic module.

Exemplarily, 10 mm ≤ *H1* ≤ 50 mm. The size of the first adhesive film 121 in the first direction X may be 10 mm, 12 mm, 14 mm, 16 mm, 18 mm, 20 mm, 22 mm, 24 mm, 26 mm, 28 mm, 30 mm, 32 mm, 34 mm, 36 mm, 38 mm, 40 mm, 42 mm, 44 mm, 46 mm, 48 mm, 50 mm, etc.

Exemplarily, 50 mm ≤ *H1* ≤ 100 mm. The size of the first adhesive film 121 in the first direction X may be 50 mm, 52 mm, 54 mm, 56 mm, 58 mm, 60 mm, 62 mm, 64 mm, 66 mm, 68 mm, 70 mm, 72 mm, 74 mm, 76 mm, 78 mm, 80 mm, 82 mm, 84 mm, 86 mm, 88 mm, 90 mm, 92 mm, 94 mm, 96 mm, 98 mm, 100 mm, etc.

A size of the first adhesive film in the second direction Y is denoted as *H2*, and 10 mm ≤ *H2* ≤ 100 mm. Exemplarily, the size of the first adhesive film 121 in the second direction Y may be 10 mm, 20 mm, 30 mm, 40 mm, 50 mm, 60 mm, 70 mm, 80 mm, 90 mm, 100 mm, etc.

If the size of the first adhesive film 121 in the second direction Y is relatively small, then the shielding effect of the first adhesive film 121 on the joint gap would be relatively poor, leading to higher risk of moisture intrusion into the laminate.

If the size of the first adhesive film 121 in the second direction Y is relatively large, then the material costs of the first adhesive film 121 would be relatively high.

Therefore, with 10 mm ≤ *H2* ≤ 100 mm, not only the shielding effect of the first adhesive film 121 on the joint gap can be improved to reduce the risk of moisture intrusion into the laminate, thereby reducing the risks, such as aging and short-circuiting of the cell pieces, improving the performance of the photovoltaic module, and prolonging the service life of the photovoltaic module, but also the material costs of the first adhesive film 121 can be reduced, thereby reducing the costs of the photovoltaic module.

Exemplarily, 10 mm ≤ *H2* ≤ 50 mm. The size of the first adhesive film 121 in the second direction Y may be 10 mm, 12 mm, 14 mm, 16 mm, 18 mm, 20 mm, 22 mm, 24 mm, 26 mm, 28 mm, 30 mm, 32 mm, 34 mm, 36 mm, 38 mm, 40 mm, 42 mm, 44 mm, 46 mm, 48 mm, 50 mm, etc.

Exemplarily, 50 mm ≤ *H2* ≤ 100 mm. The size of the first adhesive film 121 in the second direction Y may be 50 mm, 52 mm, 54 mm, 56 mm, 58 mm, 60 mm, 62 mm, 64 mm, 66 mm, 68 mm, 70 mm, 72 mm, 74 mm, 76 mm, 78 mm, 80 mm, 82 mm, 84 mm, 86 mm, 88 mm, 90 mm, 92 mm, 94 mm, 96 mm, 98 mm, 100 mm, etc.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A photovoltaic module, comprising:
a laminate (1) comprising a cell layer (13);
an insulating member (3) arranged at an edge of the laminate (1) and in contact with the laminate (1) along a peripheral direction of the laminate (1); and
a border frame (2), with the edge of the laminate (1) being positioned within the border frame (2), and with the insulating member (3) being positioned between the edge of the laminate (1) and the border frame (2).

2. The photovoltaic module according to claim 1, wherein a projection of the cell layer (13) is located within a projected outline of the insulating member (3) in a direction perpendicular to a third direction (Z), and the third direction (Z) is a thickness direction of the photovoltaic module.

3. The photovoltaic module according to claim 1 or 2, wherein a distance between the cell layer (13) and the edge of the laminate (1) in a direction perpendicular to a third direction (Z) is greater than or equal to 2.8 mm and less than or equal to 20 mm, and the third direction (Z) is a thickness direction of the photovoltaic module.

4. The photovoltaic module according to any one of claims 1 to 3, wherein in a plane perpendicular to a third direction (Z) that is a thickness direction of the photovoltaic module, the laminate (1) comprises at least a first sidewall (14), a second sidewall (15), a third sidewall (16), and a fourth sidewall (17) that are arranged in a peripheral direction thereof;
the insulating member (3) comprises at least a first side portion (31) in contact with the first sidewall (14), a second side portion (32) in contact with the second sidewall (15), a third side portion (33) in contact with the third sidewall (16), and a fourth side portion (34) in contact with the fourth sidewall (17); and
the first side portion (31), the second side portion (32), the third side portion (33), and the fourth side portion (34) are constructed as an integrated structure.

5. The photovoltaic module according to any one of claims 1 to 3, wherein in a plane perpendicular to a third direction (Z) that is a thickness direction of the photovoltaic module, the laminate (1) comprises at least a first sidewall (14), a second sidewall (15), a third sidewall (16), and a fourth sidewall (17) that are arranged in a peripheral direction thereof;
the insulating member (3) comprises at least a first side portion (31) in contact with the first sidewall (14), a second side portion (32) in contact with the second sidewall (15), a third side portion (33) in contact with the third sidewall (16), and a fourth side portion (34) in contact with the fourth sidewall (17); and
the first side portion (31), the second side portion (32), the third side portion (33), and the fourth side portion (34) are constructed as separate structures, with a joint gap (35) formed between adjacent two of the first side portion (31), the second side portion (32), the third side portion (33), and the fourth side portion (34).

6. The photovoltaic module according to claim 5, wherein in the plane perpendicular to the third direction (Z), the joint gap (35) is not parallel to a first direction (X) that is a length direction of the photovoltaic module and is not parallel to a second direction (Y) that is a width direction of the photovoltaic module;
optionally, a minimum distance between the cell layer (13) and the edge of the laminate (1) at the joint gap (35) is denoted as *A21,* and 2.8 mm ≤ *A21* ≤ 11.3 mm;
optionally, at the joint gap (35), a distance between the edge of the laminate (1) and an outer edge of the insulating member (3) along the joint gap (35) is denoted as *A22,* and 0.1 mm ≤ *A22* ≤ 8.6 mm.

7. The photovoltaic module according to claim 5, wherein in the plane perpendicular to the third direction (Z), the joint gap (35) is parallel to a first direction (X) that is a length direction of the photovoltaic module or a second direction (Y) that is a width direction of the photovoltaic module;
optionally, a minimum distance between the cell layer (13) and the edge of the laminate (1) at the joint gap (35) is denoted as *A31,* and 10.5 mm ≤ *A31* ≤ 20 mm;
optionally, at the joint gap (35), a distance between the edge of the laminate (1) and the outer edge of the insulating member (3) along the joint gap (35) is denoted as *A32,* and 0.3 mm ≤ *A32* ≤ 0.5 mm.

8. The photovoltaic module according to claim 7, wherein the cell layer (13) comprises a plurality of cell strings and at least one busbar (133), the plurality of cell strings are arranged in the first direction (X), and the busbar (133) extends in the first direction (X);
in the second direction (Y), at least part of the busbar (133) is located between the plurality of cell strings and the edge of the laminate (1), and the busbar (133) is configured for electrically connecting the cell strings;
in the first direction (X), a distance between the busbar (133) and the edge of the laminate (1) is less than a distance between the plurality of cell strings and the edge of the laminate (1); and
a distance between the busbar (133) and the edge of the laminate (1) at the joint gap (35) is the *A31,* and 10.5 mm ≤ *A31* ≤15 mm.

9. The photovoltaic module according to any one of claims 1 to 8, wherein a distance between the cell layer (13) and the edge of the laminate (1) in a first direction (X) ranges from 6 mm to 10 mm;
a distance between the cell layer (13) and the edge of the laminate (1) in the second direction (Y) ranges from 8 mm to 10 mm; and
the first direction (X), the second direction (Y), and the third direction (Z) are perpendicular to each other.

10. The photovoltaic module according to claim 9, wherein the cell layer (13) comprises a plurality of cell strings and at least one busbar (133), the plurality of cell strings are arranged in the first direction (X), and the busbar (133) extends in the first direction (X);
at least part of the busbar (133) is located between the plurality of cell strings and the edge of the laminate (1) in the second direction (Y), and the busbar (133) is configured for electrically connecting the cell strings; and
a distance between the plurality of cell strings and the edge of the laminate (1) in the first direction (X) is denoted as *a1,* and 8 mm ≤ *a1* ≤ 10 mm;
optionally, a distance between the busbar (133) and the edge of the laminate (1) in the first direction (X) is denoted as *a2,*
*a2 < a1* and 0.5 mm ≤ *a1-a2* ≤ 2 mm, or
*a2 > a1* and 1mm ≤ *a2-a1* ≤ 8mm.

11. The photovoltaic module according to any one of claims 6 to 8, wherein the laminate (1) further comprises an encapsulation layer (12), at least a part of the encapsulation layer (12) is located on a light-facing side of the cell layer (13), and/or at least another part of the encapsulation layer (12) is located on a backlight-facing side of the cell layer (13);
the encapsulation layer (12) comprises at least a first adhesive film (123), and a projection of the joint gap (35) is within a projection region of the first adhesive film (123) in the third direction (Z); and
the first adhesive film (123) is a waterproof adhesive film;
optionally, a size of the first adhesive film (123) in the first direction (X) is denoted as *H1,* and 10 mm ≤ *H1* ≤ 100 mm, and
a size of the first adhesive film (123) in the second direction (Y) is denoted as *H2,* and 10 mm ≤ *H2* ≤ 100 mm;
optionally, a projection of the first adhesive film (123) in the third direction (Z) is fan-shaped, triangular, rectangular, L-shaped, or concentric-square-shaped.

12. The photovoltaic module according to any one of claims 1 to 11, wherein the cell layer (13) comprises a plurality of cell strings arranged in a first direction (X) that is a length direction of the photovoltaic module;
a number of the cell strings in the first direction (X) is greater than or equal to 2; and
a distance between adjacent two of the plurality of cell strings in the first direction (X) is denoted as *L1,* and 9 mm ≤ *L1* ≤ 11 mm.

13. The photovoltaic module according to any one of claims 1 to 12, wherein the cell layer (13) comprises a plurality of cell strings arranged in a second direction (Y) that is a width direction of the photovoltaic module;
a number of the cell strings in the second direction (Y) is greater than or equal to 4; and
a distance between adjacent two of the plurality of cell strings in the second direction (Y) is denoted as *L2*, and 0.5 mm ≤ *L2* ≤ 1.6 mm.

14. The photovoltaic module according to any one of claims 1 to 13, wherein the cell layer (13) comprises at least one cell string, and the cell string comprises a plurality of cell pieces (131);
a number of the cell pieces (131) included in a single cell string is denoted as *N,* and 8 ≤ *N* ≤ 24; and
a distance between adjacent two of the plurality of cell pieces (131) is denoted as *L3,* and -0.6 mm ≤ *L3* ≤ 0.8 mm.

15. The photovoltaic module according to any one of claims 1 to 14, wherein a size of the photovoltaic module in a first direction (X) is denoted as *S1,* and 1700 mm ≤ *S1* ≤ 2400 mm;
a size of the photovoltaic module in a second direction (Y) is denoted as *S2,* and 1100 mm ≤ *S2* ≤ 1350 mm; and
the first direction (X) is a length direction of the photovoltaic module, and the second direction (Y) is a width direction of the photovoltaic module.
